# EUROPEAN PATENT SPECIFICATION

(11) **EP 4 318 596 B1**
(45) Date of publication and mention of the grant of the patent: **14.01.2026**
(21) Application number: 22906029.8
(22) Date of filing: 11.10.2022
(51) Int. Cl.: H10D 30/47, H10D 62/13, H10D 30/01, H10D 64/27, H10D 64/66, H10D 62/85, H10D 64/23

(54) **HIGH ELECTRON MOBILITY TRANSISTOR STRUCTURE AND MANUFACTURING METHOD THEREFOR AND APPLICATION THEREOF**
TRANSISTORSTRUKTUR MIT HOHER ELEKTRONENMOBILITÄT UND HERSTELLUNGSVERFAHREN DAFÜR UND ANWENDUNG DAVON
STRUCTURE DE TRANSISTOR À HAUTE MOBILITÉ D'ÉLECTRONS, SON PROCÉDÉ DE FABRICATION ET SON APPLICATION

(30) Priority: 13.12.2021 CN 202111528051; 10.05.2022 CN 202210490618
(43) Date of publication of application: 07.02.2024
(73) Proprietor: Suzhou Institute of Nano-Tech and Nano-Bionics (SINANO), Chinese Academy of Sciences, Suzhou, Jiangsu 215123 (CN)
(72) Inventor: ZHOU, Yu, Suzhou, Jiangsu 215123 (CN); SUN, Qian, Suzhou, Jiangsu 215123 (CN); LI, Qian, Suzhou, Jiangsu 215123 (CN); ZHANG, Xinkun, Suzhou, Jiangsu 215123 (CN); LIU, Jianxun, Suzhou, Jiangsu 215123 (CN); ZHAN, Xiaoning, Suzhou, Jiangsu 215123 (CN); ZHONG, Yaozong, Suzhou, Jiangsu 215123 (CN); YANG, Hui, Suzhou, Jiangsu 215123 (CN)
(74) Representative: Bayramoglu et al.
(86) International application number: PCT/CN2022/124581
(87) International publication number: WO 2023/109277

(56) References cited:
- CN-A- 102 629 624
- CN-A- 102 637 726
- CN-A- 103 887 335
- CN-A- 105 470 294
- JP-A- 2000 208 754
- JP-A- 2003 142 501
- US-A1- 2014 091 309
- HUANG TONGDE ET AL: "DC and RF Performance of Gate-Last AlN/GaN MOSHEMTs on Si With Regrown Source/Drain", IEEE TRANSACTIONS ON ELECTRON DEVICES, IEEE, USA, vol. 60, no. 10, 1 October 2013 (2013-10-01), pages 3019 - 3024, XP011527340, ISSN: 0018-9383, [retrieved on 20130920], DOI: 10.1109/TED.2013.2274656
- TONGDE HUANG ET AL: "Enhancement-Mode AlN/GaN MOSHFETs on Si Substrate With Regrown Source/Drain by MOCVD", IEEE ELECTRON DEVICE LETTERS, IEEE, USA, vol. 33, no. 8, 1 August 2012 (2012-08-01), pages 1123 - 1125, XP011454219, ISSN: 0741-3106, DOI: 10.1109/LED.2012.2198911
- CHEN FU ET AL: "High-resistivity unintentionally carbon-doped GaN layers with nitrogen as nucleation layer carrier gas grown by metal-organic chemical vapor deposition", AIP ADVANCES, AMERICAN INSTITUTE OF PHYSICS, 2 HUNTINGTON QUADRANGLE, MELVILLE, NY 11747, vol. 7, no. 12, 19 December 2017 (2017-12-19), XP012224687, DOI: 10.1063/1.4990099

## Description

### TECHNICAL FIELD

The present application relates to a high-electron-mobility transistor structure as well as a fabricating method and use thereof, belonging to the technical field of semiconductor devices.

### BACKGROUND

New-generation wide bandgap semiconductor material gallium nitride (GaN) simultaneously has the advantages of high breakdown voltage (3.1MV/cm), high-electron-mobility (about 1500 cm²/V·s) and the like. A GaN-based heterostructure (such as AlGaN/GaN, AlInGaN/GaN and AlN/GaN) can form high-density two-dimensional electron gas (2DEG) without deliberate doping due to the presence of polarization effect, and therefore it becomes an ideal selection of a new-generation electronic device, namely transverse high-electron-mobility transistor (HEMT).GaN HEMT has the significant advantages of high current density, high voltage tolerance, high frequency and the like, and therefore as a radiofrequency power amplifier (PA), it has been successfully applied to 5G core infrastructures such as a base station, and is gradually replacing the traditional silicon-based lateral double-diffused metal-oxide-semiconductor (LDMOS) device and continuously plays an important role in the whole 5G communication technology.

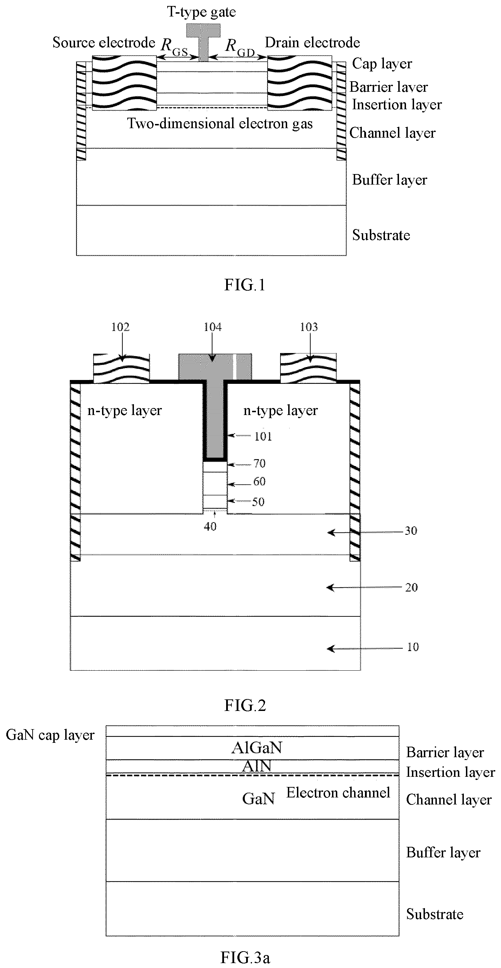

In the field of consumer electronics having a wider market prospect, the silicon-based GaN HEMT has attractions in the application of low-cost radio frequency (RF)/millimeter wave (MM Wave) as well. Compared with the traditional gallium arsenide (GaAs) heterojunction bipolar transistor (HBT), GaN HEMT exhibits stronger power output ability and more excellent heat dissipation performance, so it can stand out its inherent advantages in 5G communication services with higher power requirements, and is expected to be applied to transmitting terminal PAin RF front-end modules of mobile phones. However, currently, there is no GaN RFHEMT that is really applied to mobile terminals for the reasons that the conventional GaN HEMT has inherent defects in the aspect of device structures: along a channel direction, there are gate-source access regions and gate-drain access regions of the device, thus introducing a large proportion of series resistance *R*_{ac} so that voltages effectively applied to both sides of the channel are greatly reduced, the saturation behavior of the output current of the device is physically fundamentally restricted, thereby resulting in the occurrence of pinch saturation ahead of speed saturation so as not to reduce the Vₖₙₑₑ (Knee Voltage), as shown in FIG.1. Due to relatively low work voltage (generally 3-5 V) of a mobile intelligent terminal, the large Vₖₙₑₑ (generally 2-3V) of GaN HEMT seriously restricts its low-voltage application, and cannot play its advantage of high output power density. In another aspect, the conventional GaN HEMT structure inevitably has gate-source channel resistance *R*_{GS} which can generate a non-linear effect closely associated with electron mobility degeneration, deteriorates output current and linearity, and seriously restricts the PA application of devices in mobile intelligent terminals. In addition, the current device structure and process technology are extremely difficultly used for fabricating GaN HEMT applied to radio frequency.

In order to solve the above problems, it is a feasible solution to shorten a source-drain spacing as far as possible under the condition of allowing a semiconductor process technology. By using the solution, a source-drain high electric field can be built in a case of small source-drain voltage, so that speed saturation occurs ahead of pinch saturation, thereby effectively reducing the knee voltage. At present, researchers adopt a side wall technology to fabricate GaN HEMT having a source-drain spacing of 130 nm; also, researchers adopt the conventional photolithographic process and electron beam exposure technology to fabricate short channel GaN HEMT (<500 nm).However, neither of the devices fabricated by using the above solution avoids gate-source access regions and gate-drain access regions, so the linearity degradation of the device when outputting high current is relatively serious.

In another aspect, it is extremely difficult to fabricate enhanced GaN HEMT applied to RF (and millimeter wave) by using the conventional solution, and therefore the enhanced working mode of PA is necessary for the RF frontend of the mobile intelligent terminal in order to simplify the system and reduce the area of the chip. At present, for only Intel in the world, a barrier layer slow etching technology is utilized to fabricate enhanced GaN RFHEMT. However, this technology puts forward extremely high requirements on etching accuracy and controllability, which is difficult to achieve. Besides, researchers propose a p-NiO gate electrode technology to develop enhanced GaN RFHEMT, however, p-NiO difficultly grows to a certain extent, and has poor thermal stability. Huang Tongde et al: "DC and RF Performance of Gate-Last AIN/GaN MOSHEMTs on Si With Regrown Source/Drain" (IEEE TRANSACTIONS ON ELECTRON DEVICES, IEEE, USA, vol. 60, no. 10, 1 October 2013, pages 3019-3024) disclose the fabrication and characteristics of self-aligned gate-last AIN/GaN metal-oxide-semiconductor high electron mobility transistors (MOSHEMTs) featuring regrown source/drain for low ON-state resistance. Tongde Huang et al: "Enhancement-Mode AIN/GaN MOSFETs on Si Substrate With Regrown Source/Drain by MOCVD" (IEEE ELECTRON DEVICE LETTERS, IEEE, USA, vol. 33, no. 8, 1 August 2012) disclose enhancement-mode (e-mode) AIN/GaN MOSHFETs on Si substrates with excellent dc performance. The intriguing performance has been attributed to a combined effect of the high-quality ultrathin AIN barrier, Al2O3 as gate dielectric and passivation layer, and regrown source/drain contacts. Chen Fu et al: "High-resistivity unintentionally carbon-doped GaN layers with nitrogen as nucleation layer carrier gas grown by metal-organic chemical vapor deposition" (AIP ADVANCES, AMERICAN INSTITUTE OF PHYSICS, 2 HUNTINGTON QUADRANGLE, MELVILLE, NY 11747, vol. 7, no. 12, 19 December 2017) disclose that high-resistivity unintentionally carbon-doped GaN layers on c-plane sapphire substrates have been achieved with N2 as NL carrier gas by MOCVD. JP2003142501A, discloses a GaN HEMT with a reduced source/drain access region by providing a gate foot that has a coincidence rate between gate foot and channel of >80% as well as recessed n+ GaN source/drain regions located at both sides of said channel. Source/Drain electrodes are placed directly on top of the n+ GaN regions and isolated from the T-shaped gate electrode by a silicon Nitride (SiN) layer.

### SUMMARY

The main objective of the present application is to provide a near full-gate controlled high-electron-mobility transistor structure of T-type gate, which uses a composite layer composed of a heavily doped ohmic contact layer and a high resistance layer as a support layer and realizes spatial isolation from the heavily doped ohmic contact layer by utilizing air, as well as a fabricating method and use thereof, in order to overcome the defects in the prior art.

The invention is set out in the appended set of claims.

Compared with the prior art, the present application has the advantages:
1) the high-electron-mobility transistor structure provided by the embodiments of the present application has no gate-source access regions and gate-drain access regions, and the entire two-dimensional electronic gas carrier channel is effectively regulated by the gate electrode, and the non-linear effect induced by *R*_{GS} resistance degeneration is eliminated on the basis of achieving speed saturation and reducing the knee voltage of the device;
2) the high-electron-mobility transistor structure provided by the embodiments of the present application has high reliability, stability and transconductance, which is conducive to greatly improving the power gain of the radio frequency amplifier;
3) the fabricating method of the high-electron-mobility transistor structure provided by the embodiments of the present application adopts a self-alignment process and secondary epitaxy technology, uses the composite material of the heavily doped layer and the high resistance layer as the support layer and realizes spatial isolation from the heavily doped ohmic contact layer by utilizing air, and a T-type gate is directly built between the source electrode and the drain electrode, thereby achieving the high-electron-mobility transistor structure with a short channel, near full gate electrode control, near no access area series resistance and low parasitic effect, and improving the frequency feature, output efficiency and reliability of the device while effectively reducing the knee voltage of the device and improving the linearity of the device;
4) the high-electron-mobility transistor structure provided by the embodiments of the present application adopts a thin barrier-based heterojunction epitaxial structure, and can achieve the fabricating of the enhanced device without a groove etching technology, and the thin barrier-based material structure makes the device have large transconductance, which is conducive to improving the gain of the radio frequency power amplifier.

### BRIEF DESCRIPTION OF THE DRAWINGS

To more clearly illustrating the technical solution in the embodiments of the present application or in the prior art, the accompanying drawings required to be used in the embodiments or in the prior art will be simply discussed below, obviously, the drawings in the following description are only some embodiments of the present application, and other drawings can also be obtained by persons of ordinary skill in the art without creative efforts.
FIG.1 is a structural diagram of a high-electron-mobility transistor structure in the prior art (not constituting a part of the present invention);
FIG.2 is a structural diagram of a near-full gate controlled GaN RFHEMT provided in a typical example of the present application (not constituting a part of the present invention);
FIG.3a is a diagram of a Ga HEMT epitaxial structure provided in example 1 of the present application (not constituting a part of the present invention);
FIG.3b is a diagram of a T-type gate foot size defined on an epitaxial structure as shown in FIG.3a using HSQ electron photoresist in example 1 of the present application (not constituting a part of the present invention);
FIG.3c is a diagram after an HSQ electronic photoresist as shown in FIG.3a is annealed and cured in example 1 of the present application (not constituting a part of the present invention);
FIG. 3d is a diagram after a device structure as shown in FIG.3c is subjected to source-drain ohmic contact region etching in example 1 of the present application (not constituting a part of the present invention);
FIG. 3e is a diagram after a device structure as shown in FIG.3d is subjected to secondary epitaxy of an ohmic contact layer in example 1 of the present application (not constituting a part of the present invention);
FIG. 3f is a diagram after an HSQ electronic photoresist cured on a device structure as shown in FIG.3e is removed in example 1 of the present application (not constituting a part of the present invention);
FIG. 3g is a diagram after a device structure as shown in FIG.3f is subjected to active region isolation in example 1 of the present application (not constituting a part of the present invention);
FIG. 3h is a diagram after a dielectric layer is deposited on a device structure as shown in FIG.3g in example 1 of the present application (not constituting a part of the present invention);
FIG. 3i is a diagram after a T-type gate is fabricated on a device structure as shown in FIG.3h (not constituting a part of the present invention);
FIG. 3j is a diagram after a source electrode and a drain electrode are fabricated on a device structure as shown in FIG.3i in example 1 of the present application (not constituting a part of the present invention);
FIG. 4a is a diagram after a dielectric layer is deposited on a device structure as shown in FIG.3c in example 2 of the present application (not constituting a part of the present invention);
FIG. 4b is a diagram after a dielectric side wall is formed on a side wall of a cured HSQ electronic photoresist in FIG. 4a in example 2 of the present application (not constituting a part of the present invention);
FIG. 4c is a diagram after a device structure shown in FIG. 4b is subjected to source-drain ohmic contact region etching in example 2 of the present application (not constituting a part of the present invention);
FIG. 4d is a diagram after a device structure as shown in FIG.4c is subjected to secondary epitaxy of an ohmic contact layer in example 2 of the present application (not constituting a part of the present invention);
FIG. 4e is a diagram after a device structure shown in FIG.4d is subjected to active region isolation in example 2 of the present application (not constituting a part of the present invention);
FIG. 4f is a diagram after a source electrode and a drain electrode are fabricated on a device structure as shown in FIG.4e in example 2 of the present application (not constituting a part of the present invention);
FIG. 4g is a diagram after a sacrificial layer is spin coated on a device structure shown in FIG. 4f in example 2 of the present application (not constituting a part of the present invention);
FIG. 4h is a diagram after CMP thinning is performed on the sacrificial layer on the device structure shown in FIG. 4g in example 2 of the present application (not constituting a part of the present invention);
FIG. 4i is a diagram after an HSQ electronic photoresist on a device structure shown in FIG. 4g is removed in example 2 of the present application (not constituting a part of the present invention);
FIG. 4j is a diagram after agate electrode is deposited on a device structure shown in FIG. 4i in example 2 of the present application (not constituting a part of the present invention);
FIG. 4k is a diagram after a sacrificial layer on a device structure shown in FIG. 4j is removed in example 2 of the present application (not constituting a part of the present invention).
FIG. 5 is a structural diagram of a high-electron-mobility transistor according to the present invention;
FIG. 6 is a structural diagram of another high-electron-mobility transistor provided in a typical example of the present application (not constituting a part of the present invention);
FIG.s 7a-7k are flowcharts of fabricating a high-electron-mobility transistor structure as shown in FIG. 5 provided in example 3 of the present application;
FIG.s 8a-8b are flow charts of fabricating a high-electron-mobility transistor structure as shown in FIG. 5 provided in example 4 of the present application.

### DETAILED DESCRIPTION OF THE EMBODIMENTS

In view of the defects in the prior art, the applicant of this case puts forward the technical solution of the present application through long-term researches and lots of practices. The present application provides a high-electron-mobility transistor structure. The composite layer of the heavily doped layer and the high resistance layer is grown by secondary epitaxy. On the one hand, the heavily doped region formed by the heavily doped layer can effectively reduce the source-drain ohmic contact resistance, and on the other hand, gate-source and gate-drain high resistance materials can effectively reduce the parasitic capacitance and suppress the leakage of the gate electrode, thereby ensuring the reliability of the device while improving the frequency characteristics of the device.

One aspect of the embodiments of the present application provides a high-electron-mobility transistor structure, which, for example, can be a GaN electronic device structure, comprising:
an epitaxial structure, comprising a heterojunction comprising a first semiconductor layer and a second semiconductor layer, a carrier channel being formed between the first semiconductor layer and the second semiconductor layer; and
a source electrode, a drain electrode and a gate electrode which are matched with the epitaxial structure, the source electrode being electrically connected with the drain electrode through the carrier channel;
wherein, a coincidence rate between the orthographic projection of the gate foot of the gate electrodeon the first semiconductor layer and the orthographic projection of the second semiconductor layer on the first semiconductor layer is more than 80%, preferably more than 90%, preferably more than 95%, preferably 99%, especially preferably 100%.

That is, the orthographic projection of the gate foot of the gate electrode on the first semiconductor layer basically coincides with the orthographic projection of the second semiconductor layer on the first semiconductor layer. Preferably, the orthographic projection of the gate foot coincides with the orthographic projection of the second semiconductor layer on the first semiconductor layer.

In some embodiments, the gate electrode comprises a first part and a second part which are successively distributed in a direction away from the second semiconductor layer, wherein the first part is the gate foot and the radial size of the first part is smaller than or equal to that of the second part. Especially, the gate electrode consists of the first part and the second part, the radial size of the first part is smaller than that of the second part. Where, the first part and the second part can be integrally formed.

In some specific embodiments, the gate electrode is a T-type gate, but is not limited thereto. For example, the gate electrode can also be a T-type gate, a trapezoid-type gate electrode, etc.

In some embodiments, the second semiconductor layer is relatively thin and the gate electrode is isolated from the second semiconductor layer by the dielectric layer, thereby forming an Enhancement-mode device. Of course, the second semiconductor layer is relatively thick and the dielectric layer cannot be arranged between the gate electrode and the second semiconductor layer, thereby forming a depletion-mode device.

In some embodiments, an insertion layer is also arranged between the first semiconductor layer and the second semiconductor layer.

In some embodiments, a cap layer is also distributed between the dielectric layer and the second semiconductor layer.

The epitaxial structure also comprises an ohmic contact layer, the ohmic contact layer is in contact with the carrier channel, the source electrode and the drain electrode are both arranged on the ohmic contact layer and form ohmic contact with the ohmic contact layer.

Further, the ohmic contact layer is arranged on the first semiconductor layer and is in contact with the carrier channel.

The ohmic contact layer and the carrier channel form ohmic contact.

In some embodiments, a groove is distributed between a source electrode region and a drain electrode region on the ohmic contact layer, the bottom of the at least gate foot and the second semiconductor layer are both arranged in the groove. Further, the gate foot of the gate electrode can be entirely arranged in the groove.

Further, an included angle of 60-90° is formed between the side wall of the groove and the surface of the first semiconductor layer, especially preferably an included of 90°. That is, the side wall of the groove is almost vertical to the surface of the first semiconductor layer.

Further, the gate cap of the gate electrode covers the groove.

In some embodiments, the gate electrode is electrically isolated from the ohmic contact layer by the dielectric layer, the dielectric layer arranged between the gate electrode and the ohmic contact layer can be defined as a dielectric side wall; or, the gate electrode is isolated from the heavily doped ohmic contact layer by air.

More preferably, the epitaxial structure can adopt a thin barrier structure. Of course, in same cases, the epitaxial structure can also adopt a thick barrier structure.

More preferably, the radial size of the gate foot of the gate electrode can be set as 10 nm-500 nm.

In some embodiments, the epitaxial structure can further comprise a P-type layer arranged on the second semiconductor layer, etc., and the gate electrode is arranged on the P-type layer, so as to form a P-type gate enhanced device.

In some embodiments, the ohmic contact layer is also provided with a sacrificial layer, and the at least local regions of the source electrode, the drain electrode and the gate electrode are exposed out of the sacrificial layer. The material of the sacrificial layer includes but is not limited to PI glue, BCB glue (Benzo-Cyclobutene), SOG (Spin-on-glass) or other low-k dielectric materials, and can be removed by technological means, so as to realize spatial separation with the heavily doped ohmic contact layer by utilizingair.

Further, the epitaxial structure is made from III-V group compounds. The above-mentioned first semiconductor layer can be understood as a channel layer, and the material of the first semiconductor layer is GaN. The above-mentioned second semiconductor layer can be understood as a barrier layer, and the material of the second semiconductor layer is AlGaN. The material of the above-mentioned insertion layer can include AlN, etc.

In some embodiments, the material of the dielectric layer includes Al₂O₃, SiO₂, HfO₂, AlON, silicon nitride and the like, or combinations thereof, such as Al₂O₃/AlN, Al₂O₃/HfO₂ and other composite gate electrode media, but is not limited thereto.

In some embodiments, the GaN electronic device structure includes an N-polar HEMT device structure or an HEMT device structure with a back barrier structure, but is not limited thereto.

In some embodiments, the high-electron-mobility transistor structure also includes a substrate where the epitaxial structure is formed. The material of the substrate includes but is not limited to silicon, sapphire, silicon carbide, gallium nitride, aluminum nitride, etc. In addition, the epitaxial structure can also include a nucleating layer, a buffer layer and the like which are grown on the substrate in turn, which is familiar in the art and will not be described in detail here.

In the above embodiments of the present application, a GaN electronic device structure with short channel, full gate electrode control, series resistance and no near access regions is formed by directly constructing a gate electrode (such as a T-type gate electrode) between the source electrode and the drain electrode, which can effectively reduce the knee voltage of the device and improve the linearity of the device. Moreover, the GaN electronic device structure is completely suitable for depletion-mode and enhancement-mode HEMT devices. In particular, when athin barrier-based heterojunction epitaxial structure is adopted, the enhanced device can be realized without a groove gate etching process. Meanwhile, the device has large transconductance, which is conducive to significantly improving the PA power gain of the device.

The present application further provide a fabricating method of a high-electron-mobility transistor structure, comprising:

a step of fabricating an epitaxial structure, the epitaxial structure comprising a heterjunction comprising a first semiconductor layer and a second semiconductor layer, and a carrier channel being formed between the first semiconductor layer and the second semiconductor layer, and

a step of fabricating a source electrode, a drain electrode and a gate electrode which are matched with the epitaxial structure, the source electrode being electrically connected with the drain electrode through the carrier channel;

wherein, the step of fabricating the gate electrode comprises: the size of the gate foot of the gate electrode is set to meet the following conditions: a coincidence rate between the orthographic projection of the gate foot of the gate electrode on the first semiconductor layer and the orthographic projection of the second semiconductor layer on the first semiconductor layer is more than 80%, preferably more than 90%, preferably more than 95%, preferably more than 99%, especially preferably 100%. That is, the orthographic projection of the gate foot on the first semiconductor layer almost covers the orthographic projection of the second semiconductor layer on the first semiconductor layer.

The fabricating method specifically comprises:
successively growing a first semiconductor layer and a second semiconductor layer on a substrate;
arranging a mask on the gate electrode region of the second semiconductor layer, wherein the radial size of the mask is consistent to that of the gate foot;
etching to remove the region of the second semiconductor layer that is not protected by the mask, wherein the etching depth is a depth of reaching the surface of the first semiconductor layer or entering the first semiconductor layer;
at least growing ohmic contact layers on the source electrode region and the drain electrode region of the first semiconductor layer, and allowing the height of the surface of the second semiconductor layer to be below the height of the surface of the ohmic contact layer, and contacting the ohmic contact layer with the carrier channel;
fabricating a gate electrode on the second semiconductor layer after the mask is removed, and respectively fabricating the source electrode and the drain electrode on the source electrode region and the drain electrode region of the ohmic contact layer, and allowing the source electrode and the drain electrode to form ohmic contact with the ohmic contact layer;
the ohmic contact layer and the carrier channel form ohmic contact.

In some embodiments, the fabricating method further comprises: growing an ohmic contact layer on a region of the surface of the first semiconductor layer that is not covered by the second semiconductor layer, and allowing the surface of the ohmic contact layer to be higher than that of the surface of the second semiconductor layer, so as to form a groove in the ohmic contact layer, then removing the mask and fabricating the gate electrode, and at least allowing the bottom of the gate foot to be distributed in the groove.

In some embodiments, the fabricating method further comprises: after the ohmic contact layer is grown, removing the mask and then forming a continuous dielectric layer on the ohmic contact layer and the second semiconductor layer, then fabricating the gate electrode on the dielectric layer, and forming a window on the dielectric layer, and fabricating the source electrode and the drain electrode in the window.

Where, a process of fabricating the gate electrode can be carried out before or after a process of fabricating the source electrode and the drain electrode.

In some embodiments, the fabricating method further comprises: after the ohmic contact layer is grown, fabricating the source electrode and the drain electrode on the ohmic contact layer, then forming a continuous sacrificial layer on the ohmic contact layer, and embedding the source electrode and the drain electrode into the sacrificial layer, and at least allowing the surface of the mask to be exposed out of the sacrificial layer, then removing the mask layer, and fabricating the gate electrode on the second semiconductor layer;
where, all the source electrode, the drain electrode and the mask can be completely embedded in the sacrificial layer, and then the mask part can be exposed out of the sacrificial layer through polishing (such as CMP, chemical mechanical polishing) and other processes.

After the fabrication of the source electrode, drain electrode and gate electrode is completed, the sacrificial layer can be removed, so as to realize spatial isolation from the heavily doped ohmic contact layer by utilizing air, or the sacrificial layer can be retained and used as a support layer for the gate electrode and the like.

In some embodiments, the fabricating method specifically comprises: arranging the mask on the gate electrode region of the second semiconductor layer, and at least forming the dielectric layer on the side wall of the mask, then successively etching the second semiconductor layer and growing the ohmic contact layer on the first semiconductor layer.

In some embodiments, the fabricating method further comprises: performing an operation of active region isolation on the epitaxial structure, wherein such the operation can be implemented according to well-known modes in the art.

In some embodiments, the gate electrode includes a gate foot and a gate cap which are sequentially distributed in a direction away from the second semiconductor layer, wherein the radial size of the gate foot is smaller than or equal to that of the gate cap. Preferably, the gate electrode includes a T-type gate, but is not limited thereto.

In the above embodiments of the present application, the mask can be formed by a photoresist or a dielectric film, and can be graphically processed by exposure, developing and other methods that are familiar in the art, and can also be removed by wet etching and other modes that are familiar in the art.

In the above embodiments of the present application, each structural layer in the epitaxial structure can be grown by metal organic vapor deposition (MOCVD), atomic layer deposition (ALD), plasma enhanced chemical vapor deposition (PECVD) and other physical and/or chemical vapor deposition methods that are familiar in the art.

In the above embodiments of the present application, the dielectric layer can be fabricated by ALD or other physical and chemical vapor deposition methods.

In the above embodiments of the present application, the source electrode, the drain electrode and the gate electrode can be formed by sputtering, evaporation and other methods that are known in the art and a metal stripping technology.

In preferred embodiments of the present application, the above-mentioned GaN electronic device structure is fabricated by using thin barrier heterostructure-based GaN HEMT epitaxial structure and by virtue of secondary epitaxial growth ohm technology, which can be defined as a near-full gate controlled short channel device. This GaN electronic device structure can simultaneously realize a low knee voltage and an enhanced operation mode, thus meeting the RF front-end PA application scenarios. Compared with the existing GaN RFHEMT, this GaN electronic device structure has no gate-source access regions and gate-drain access regions, and the entire short channel is effectively regulated by the gate electrode, thereby eliminating the nonlinear effect induced by *R*_{GS} resistance degradation on the basis of achieving speed saturation. In particular, in the aspect of implementing the enhanced working mode, since the epitaxial structure of this GaN electronic device structure uses a thin barrier and does not require dry etching and other processes, thus avoiding the etching damage of the existing groove gate enhanced HEMT device during the fabricating so as to greatly improve the fabricating reliability and stability of the device; in the aspect of suppressing the parasitic effect, the high-frequency parasitic effect can be greatly suppressed due to the T-type gate structure that realizes spatial isolation from the heavily doped ohmic contact layer by utilizing air. Meanwhile, the thin barrier means a large gate capacitance, which is helpful to greatly improve the transconductance of this GaN electronic device structure, thus ultimately improving the power gain of PA.

Some embodiments of the present application also provide the use of the GaN electronic device structure in fabricating power amplifiers, radio frequency devices, communication devices or electronic devices. Further, the power amplifier can be a RF wave band power amplifier, or a millimeter wave band power amplifier, a terahertz wave band power amplifier, etc., and is not limited thereto. The electronic devices can be mobile phones, tablet computers or other smart devices, and are not limited thereto.

Another aspect of the present application also provides a high-electron-mobility transistor structure, including an epitaxial structure, and a source electrode, a drain electrode and a gate electrode which are matched with the epitaxial structure. The epitaxial structure includes a heterojunction where a carrier channel is formed, and the carrier channel is distributed in a region covered by the orthographic projection of the gate electrode on the epitaxial structure; wherein, the epitaxial structure also includes a heavily doped region and a high resistance region. The heavily doped region is arranged on the heterojunction and forms ohmic contact with the carrier channel. Both the source electrode and the drain electrode form ohmic contact with the heavily doped region. The high resistance region is arranged on the heavily doped region, and the source electrode is isolated from the gate electrode by the high resistance region, and the drain electrode is isolated from the gate electrode by the high resistance region.

It should be noted that the heavily doped region and high resistance region can be considered as the highly doped ohmic contact layer.

The upper surface of the heavily doped region is higher than the surface of the carrier channel.

Where, the material of the heavily doped region is GaN. The material of the high resistance region is high resistance GaN material.

The heavily doped region includes a first heavily doped region matched with the source electrode and a second heavily doped region matched with the drain electrode. The first heavily doped region and the second heavily doped region are respectively located at both sides of the second semiconductor layer, and the high resistance region includes a first high resistance region matched with the source electrode and a second high resistance region matched with the drain electrode. The at least local regions of the source electrode and the drain electrode pass through the first high resistance region and the second high resistance region and then form ohmic contact with the first heavily doped region and the second heavily doped region. The first heavily doped region and the first high resistance region jointly constitute the source electrode contact region of the high-electron-mobility transistor structure, and the second heavily doped region and the second high resistance region jointly constitute the drain electrode contact region of the high-electron-mobility transistor structure.

Where, the first semiconductor layer is the first semiconductor layer of the high-electron-mobility transistor structure, the thickness of the first semiconductor layer is 5-200nm, and the material of the first semiconductor is GaN material; the second semiconductor layer is the second semiconductor layer of the high-electron-mobility transistor structure. The thickness of the second semiconductor layer is 1-100 nm, and the material of the second semiconductor layer is AlGaN.

**In** some embodiments, the carrier channel can be a two-dimensional electron gas channel, and the heavily doped region is of n type; or, the carrier channel is a two-dimensional hole gas channel, and the heavily doped region is of p type.

**In** some embodiments, the material of the epitaxial structure can be a Ga polar surface or an N polar surface. A device structure with the two-dimensional electron gas channel, which is fabricated on the Ga polar surface, is consistent with a device structure with a two-dimensional hole gas channel, which is fabricated on the N-polar surface. The device structure with the two-dimensional hole gas channel, which is fabricated on the Ga polar surface is consistent with device structure with the two-dimensional electron gas channel, which is fabricated on the N-polar surface.

In some embodiments, the first semiconductor layer includes a first region and a second region, a bulge portion is formed on the first region, the second semiconductor layer is arranged on the bulge portion, the first heavily doped region and the second heavily doped region are arranged on the second region and distributed at both sides of the bulge portion.

In some embodiments, the epitaxial structure further includes a cap layer arranged on the second semiconductor layer. The thickness of the cap layer is 0-100nm. The material of the cap layer can be a GaN material and SiN, but are not limited thereto.

In some embodiments, the epitaxial structure further includes an insertion layer distributed between the first semiconductor layer and the second semiconductor layer. The thickness of the insertion layer is 0-10nm, and the material of the insertion layer can be an AlN material, but is not limited thereto.

In some embodiments, the epitaxial structure further includes a buffer layer distributed between the substrate and the first semiconductor layer.

In some embodiments, the buffer layer can be selectively doped.

In some embodiments, the epitaxial structure further includes a back barrier layer distributed between the buffer layer and the first semiconductor layer. The material of the back barrier layer can be AlN and AlGaN, but is not limited thereto.

In some embodiments, the gate electrode can be a T-type gate, which includes a gate cap and a gate foot which are arranged in an axial direction, wherein the gate cap is arranged on the high resistance region and supported by the high resistance region, the gate foot is arranged in the epitaxial structure, the size of the gate cap in a source-drain channel direction is larger than that of the gate foot in the source-drain channel direction, and the carrier channel is distributed right below the gate foot, and the size of the gate foot in the source-drain channel direction is smaller than or equal to the length of the two-dimensional electron gas channel.

In some preferred embodiments, a side wall dielectric layer is also arranged between the side wall of the gate foot and the high resistance region, and the material of the side wall dielectric layer can be SiN. The method for forming the side wall dielectric layer can be a low pressure chemical vapor deposition (LPCVD) method, but is not limited thereto.

In some embodiments, a dielectric layer is also arranged between the gate electrode and the heterojunction. The material of the dielectric layer can be one or more of SiO₂, HfO₂, Al₂O₃, AlN, AlON and SiN. The method for forming the dielectric layer can be the ALD method, and is not limited thereto.

In some embodiments, the dielectric layer also extends to cover the surface of the epitaxial structure, and the source electrode and the drain electrode are matched with the epitaxial structure through the corresponding window formed on the dielectric layer.

In some embodiments, the dielectric layer is also used for electrically isolating the gate electrode and the high resistance region, or the gate electrode is directly isolated from the high resistance region by air.

In some embodiments, the high resistance region can be epitaxially formed on the heavily doped region in a secondary epitaxy mode, or be formed by local transformation of the heavily doped region. For example, the heavily doped region material can be transformed into high resistance material through thermal diffusion, ion injection, plasma treatment and other methods, or by any other ways that can form the high resistance material layer.

In the above embodiments, an interface between the heavily doped region and the high resistance region can be controlled by gradual doping as long as it is ensured that the surface of the heavily doped region is higher than the surface of the carrier channel.

In some embodiments, the high-electron-mobility transistor structure also includes an isolation region which is formed in the epitaxial structure and used for isolating the active region of the high-electron-mobility transistor structure. The isolation region is distributed at both sides of the epitaxial structure, which at least extends from the surface of the epitaxial structure below the first semiconductor layer in the axial direction.

In some embodiments, the isolation region can be formed by an N ion injection technology, with an injection energy being 100-400keV and an N ion injection dose being 10¹²-10¹⁷/cm², and the injection depth is below the first semiconductor layer. The isolation region can adopt the etching method to etch the epitaxial layer of the active region below the first semiconductor layer.

Another aspect of the present application also provides a fabricating method of a high-electron-mobility transistor structure, including:
successively arranging a first semiconductor layer and a second semiconductor layer to form a heterojunction, and allowing the carrier channel to be distributed in a region covered by the orthographic projection of the gate electrode on the epitaxial structure;
fabricating a heavily doped region and a high resistance region on the heterojunction, and arranging the high resistance region on the heavily doped region, and allowing the heavily doped region to form ohmic contact with the carrier channel, thus forming an epitaxial structure; and
fabricating a source electrode, a drain electrode and a gate electrode which are matched with the epitaxial structure, and allowing the source electrode and the drain electrode to form ohmic contact with the heavily doped region, and isolating the source electrode from the gate electrode by the high resistance region and isolating the drain electrode from the gate electrode by the high resistance region.

Further, the fabricating method specifically comprises:
successively growing a first semiconductor layer and a second semiconductor layer on a substrate in turn;
arranging a mask on a region of the surface of the second semiconductor layer corresponding to the gate electrode, etching the second semiconductor layer and the first semiconductor layer by using the mask until both the source electrode contact region and the drain electrode contact region of the second semiconductor layer are completely removed, and both the source electrode contact region and the drain electrode contact region of the first semiconducting layer are partially removed, so that the region of the first semiconductor layer corresponding to the gate electrode is formed into a bulge portion, and the rest part of the second semiconductor layer is distributed on the bulge portion;
growing a heavily doped layer on the rest part of the source electrode contact region and the drain electrode contact region of the first semiconductor layer to form a heavily doped region, and allowing the surface of the heavily doped region to be higher than the surface of the carrier channel, and then growing a high resistance layer on the heavily doped layer to form a high resistance region, thus forming the epitaxial structure,
or, growing a heavily doped layer on the rest part of the source electrode contact region and the drain electrode contact region of the first semiconductor layer, and then transforming the semiconductor material at a specified depth from the surface of the heavily doped layer to the inside of the heavily doped layer into a high resistance material, so as to form a high resistance region and a heavily doped region in the heavily doped layer, wherein the specified depth is higher than the surface of the carrier channel, thus forming the epitaxial structure;
removing the mask, and fabricating the gate electrode, the source electrode and the drain electrode.

In some embodiments, the materials of the source electrode and the drain electrode can be Ti/Al/Ni/Au, or other metal systems that can form ohmic contact with n-type or p-type heavily doped regions; the material of the gate electrode can be Ni/Au, or a material system which can form Schottky contact with the second semiconductor layer, such as Ni/Pt/Au, Ni/Pt and P-GaN.

In some embodiments, the fabricating method specifically further includes: forming a dielectric layer between the gate electrode and the heterojunction.

In some embodiments, the fabricating method specifically further includes: forming a side wall dielectric layer between the gate foot of the gate electrode and the high resistance region.

It should be noted that under the condition that the growth shape of the ohmic contact region composed of the high resistance region and the heavily doped region can be regulated, the dielectric layer or the side wall dielectric layer cannot be formed as well.

In some embodiments, the fabricating method specifically further includes: forming a buffer layer between the substrate and the first semiconductor layer.

In some embodiments, the material of the substrate can be selected from any one of silicon, sapphire, silicon carbide, gallium nitride and aluminum nitride, and is not limited thereto.

In some more specific embodiments, the fabricating method can include the following steps:
Step 1), the buffer layer, the first semiconductor layer, the insertion layer, the second semiconductor layer and the cap layer are successively epitaxially grown on the substrate, and the carrier channel is formed under the surface of the first semiconductor layer close to the insertion layer;
Step 2), the size of the gate foot of the T-type gate is defined on the epitaxial structure through an electronic photoresist, that is, the gate length LG ≈ 50-500 nm;
Step 3), the electronic photoresist is cured by an annealing process, wherein the annealing temperature is about 400°C;
Step 4), a layer of side wall dielectric layer is deposited on the surface of the device formed in Step 3), and then the side wall dielectric layers are etched away on the cap layer and the upper surface of the electronic photoresist by using a self-aligned etching technology;
Step 5), the source electrode contact region and the drain electrode contact region are etched based on the cured electronic photoresist as the mask, and the cap layer, the second semiconductor layers, the insertion layers and a part thickness of first semiconductor layers of the source electrode contact region and the drain electrode contact region are removed;
Step 6), the heavily doped layer is epitaxially grown in the source electrode contact region and the drain electrode contact region which are subjected to etching by continuing to use the cured electronic photoresist as the mask to form a heavily doped region, the thickness and doping concentration of the heavily doped region ensure that the heavily doped region forms good ohmic contact with the carrier channel, and then a high resistance layer is epitaxially grown on the heavily doped region to form a high resistance region;
Step 7), the electronic photoresist is removed;
Step 8), the isolation region of the active region is formed at both sides of the epitaxial structure;
Step 9), a dielectric layer is deposited on the device surface formed in Step 8);
Step 10), the T-type gate is fabricated by using the high resistance layer as the support layer of the T-type gate cap;
Step 11), a window is formed on the gate dielectric layer and the high resistance layer, and a source electrode and a drain electrode are fabricated in the window, so that the source electrode and the drain electrode form ohmic contact with the heavily doped layer.

In other more specific embodiments, in Step 6), the cured electronic photoresist is used as the mask, the heavily doped layer is epitaxially grown in the source electrode contact region and the drain electrode contact region which are subjected to etching to form the heavily doped region, the thickness and doping concentration of the heavily doped region ensure that the heavily doped region forms good ohmic contact with the carrier channel, and then the semiconductor material at the specified depth from the surface of the heavily doped layer to the inside of the heavily doped layer is transformed into the high resistance material, thus forming the high resistance region and the heavily doped region in the heavily doped layer, and the specified depth is higher than the surface of the carrier channel.

Another aspect of the present application further provides a power amplifier, including the high-electron-mobility transistor structure.

**In** some embodiments, the power amplifier includes radio frequency wave band power amplifier, a millimeter wave band power amplifier or a terahertz wave band power amplifier, etc.

Referring to FIG.2, a GaN electronic device structure is a near-full gate controlled GaN HEMT structure, including a buffer layer 20, a channel layer 30, an insertion layer 50, a barrier layer 60, a cap layer 70 and the like which are successively grown on a substrate 10, and an n-type layer (i.e., the above-mentioned ohmic contact layer) is also grown on the surface of the channel layer 30, and the n-type layer is also in contact with the insertion layer 50, the barrier layer 60, the cap layer 70 and the like, so as to form an epitaxial structure, the channel layer 30, the insertion layer 50 and the barrier layer 60 form a heterojunction, and a two-dimensional electron gas channel 40 is formed between the channel layer 30 and the insertion layer 50.

In this embodiment, a groove is formed in this n-type layer. The insertion layer 50, the barrier layer 60and the cap layer 70 are all distributed in the groove. Where, the gate electrode 104 is a T-type gate, and the gate foot of the gate electrode is also arranged in the groove. The gate cap is arranged on the n-type layer. The source electrode 102 and the drain electrode 103 are formed on the n-type layer and form ohmic contact with the n-type layer.

This epitaxial structure can also have an active region isolation structure formed by ion injection and other methods. Meanwhile, a continuous dielectric layer 101 can be formed between the n-type layer and the cap layer 70 and the gate electrode 104, thus forming an enhanced device.

In this embodiment, this epitaxial structure preferably adopts a thin barrier design. Through such the design, on the one hand, short channel devices can be fabricated, and the entire channel is almost effectively controlled by the gate electrode (that is, the gate length *L*_{G} ≈ source-drain spacing *L*_{DS}). Because there are no gate-source access regions and gate-drain access regions, the linearity degeneration problem of the device caused by *R*_{GS} high-field non-linear behavior can be effectively suppressed while significantly reducing the difficulty of obtaining the low knee voltage of the device; on the other hand, since the thin barrier epitaxial structure is adopted and the gate electrode can perform electron concentration regulation on the entire channel, the enhanced device can be fabricated without the help of a complex technology. Meanwhile, the thin barrier means the large gate capacitance, which is conducive to improving the transconductance of the device so as to ultimately improve the PA power gain.

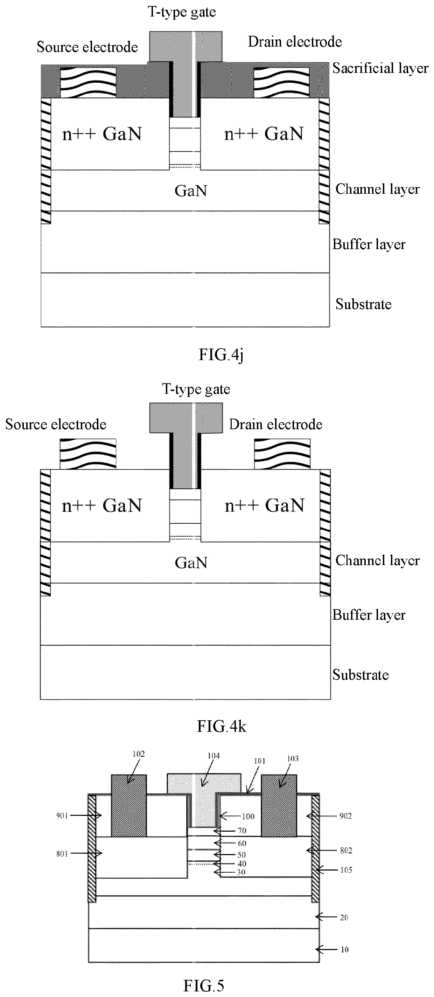

Referring to FIG.5, an n-type channel high-electron-mobility transistor structure provided by the embodiment of the present application includes a substrate 10, an epitaxial structure formed on the substrate 10, and a source electrode 102, a drain electrode 103 and a gate electrode 104 which are matched with the epitaxial structure. The epitaxial structure includes a GaN buffer layer 20, a GaN first semiconductor layer 30, an AlN insertion layer 50, an AlGaN second semiconductor layer 60and a GaN cap layer 70 which are successively formed on the sapphire substrate 10, and the GaNfirst semiconductor layer 30 includes a first region and a second region. The bulge portion is formed on the first region. The AlN insertion layer 50, the AlGaN second semiconductor layer 60 and the GaN cap layer 70 are successively arranged on the bulge portion i, wherein the GaN first semiconductor layer 30, the AlN insertion layer 50 and the AlGaN second semiconductor layer 60 form a heterojunction, and a two-dimensional electron gas channel 40 is formed under the surface of the GaN first semiconductor layer 30 close to the AlN insertion layer 50, and this two-dimensional electron gas channel 40 is distributed in a region covered by the orthographic projection of the gate electrode 104 on the epitaxial structure.

Further, the epitaxial structure further includes a heavily doped region and a high resistance region. The heavily doped region includes a first heavily doped region 801 which is matched with the source electrode 102 and a second heavily doped region 802 which is matched with the drain electrode 103. The first heavily doped region 801 and the second heavily doped region 802 are arranged on the second region of the GaN second semiconductor layer 30 and form good ohmic contact with the two-dimensional electron gas channel 40, the high resistance region includes a first high resistance region 901 which is matched with the source electrode 102 and a second high resistance region 902 which is matched with the drain electrode 103. The local regions of the source electrode 102 and the drain electrode 103 pass through the first high resistance region 901 and the second high resistance region 902 and then respectively form ohmic contact with the first heavily doped region 801 and the second heavily doped region 802, and the source electrode 102 is isolated from the gate electrode 104 by the first high resistance region 901, the drain electrode 103 is isolated from the gate electrode 104 by the second high resistance region 902, and the surfaces of the first heavily doped region 801 and the second heavily doped region 802 are higher than the surface of the two-dimensional electron gas channel 40.

Where, the first heavily doped region 801 and the second heavily doped region 802 are n-type heavily doped GaN materials, and the first high resistance region 901 and the second high resistance region 902 are high resistance GaN materials.

Specifically, the gate electrode 104 is a T-type gate, which includes a gate cap and a gate foot which are arranged in the axial direction, wherein the two ends of the gate cap are respectively arranged on the first high resistance region 901 and the second high resistance region 902 and supported by the first high resistance region 901 and the second high resistance region 902, and the gate foot is arranged in the epitaxial structure, the diameter of the gate cap is greater than that of the gate foot, and the two-dimensional electronic gas channel 40 is distributed right below the gate foot, and the diameter of the gate foot is greater than or equal to the length of the two-dimensional electron gas channel 40, so as to achieve a near-full gate controlled high-electron-mobility transistor structure.

Specifically, SiN side wall dielectric layers 100 are also arranged between the gate foot of the gate electrode 104 and the first high resistance region 901 and between the gate foot of the gate electrode 104 and the second high resistance region 902, and a Al₂O₃ dielectric layer 101 is also arranged between the gate electrode 104 and the surface of the epitaxial structure.

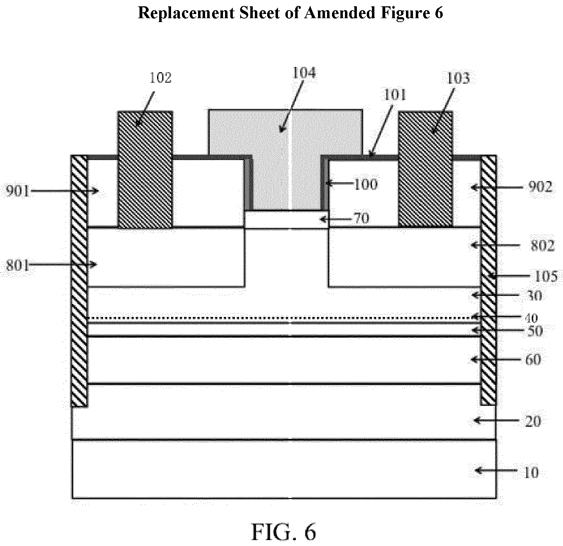

Next, referring to FIG. 6. The n-type channel high-electron-mobility transistor structure with an N polar surface provided by the embodiment of the present application is different from the n-type channel high-electron-mobility transistor structure shown in FIG.5 in that the two-dimensional electron gas channel 40 is formed on the surface of the GaN first semiconductor layer 30 close to the AlN insertion layer 50, and the AlGaN second semiconductor layer 60 is arranged below the GaN first semiconductor layer 30.

Next, the technical solution of the present application will be further described in detail in combination with embodiments and accompanying drawings. These embodiments are implemented on the premise of the technical solution of the present application, and the detailed embodiments and specific operation processes are given, however, the protection scope of the present application is not limited to the following examples.

### Example 1 (not constituting a part of the present invention)

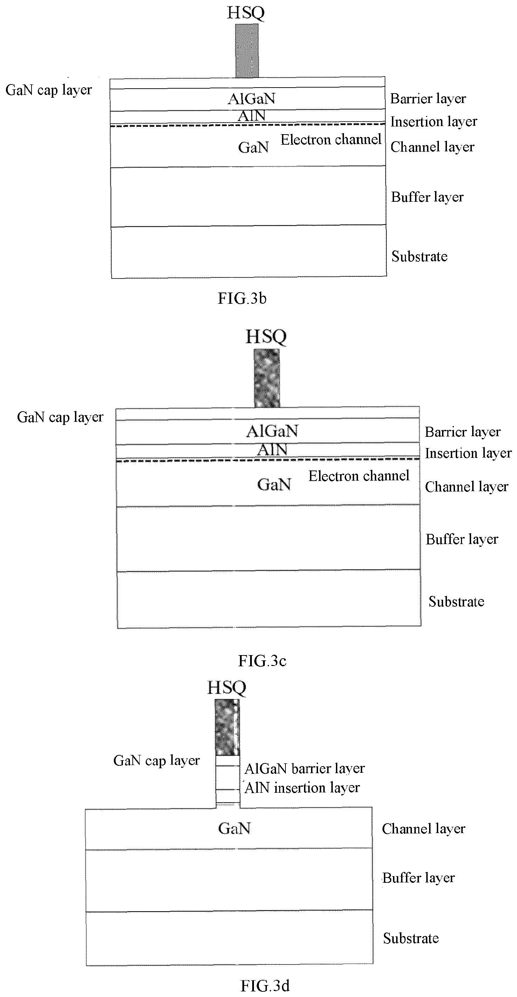

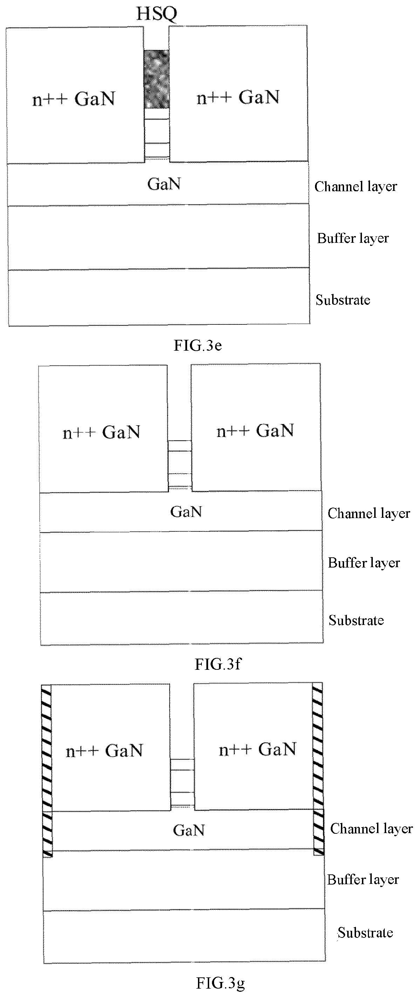

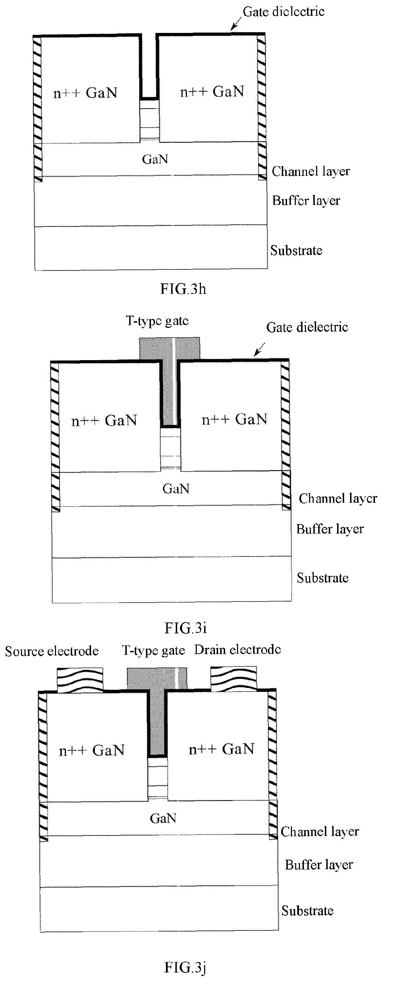

**A** GaN HEMT structure (hereinafter called a device for short) provided in this example is basically the same as a GaN electronic device structure as shown in FIG. 1, wherein an ohmic contact layer formed by directly utilizing secondary epitaxy is used as a T-type gate support layer. A fabricating method of this device can include the following steps:
S1, epitaxial structures of a device based on a thin second semiconductor layer heterojunction were epitaxially grown through metal organic chemical vapor deposition (MOCVD), as shown in FIG.3a. In one of the epitaxial structures, a second semiconductor layerwas Al_{0.2}Ga_{0.8}N with a thickness of about 5 nm; a GaN cap layer was about 2 nm in thickness; an AlN insertion layer was about 1 nm in thickness; a GaN first semiconductor layer is 5-200 nm in thickness.
S2, the size, namely, the gate electrode length *L*_{G}, of the gate foot of theT-type gate electrode (called "T-type gate" for short) of the device was defined by using hydrogen silsesquioxane (HSQ) electronic photoresist or other photoresists, as shown in FIG.3b. For one of the T-type gates, the gate electrode length *L*_{G} ≈ 50nm-250 nm.
S3, the HSQ electronic photoresist was cured by using an annealing process, wherein the adopted annealing temperature was about 400°C, as shown in FIG.3c.
S4, a source-drain ohmic contact region was etched. The gate electrode of the source-drain ohmic contact region was etched by adopting an inductive coupled plasma (ICP) etching technology and using the cured HSQ electronic photoresist as a mask, wherein the etching rate was controlled to 1-20 nm/min, as shown in FIG.3d.
S5, the secondary epitaxy was performed on the ohmic contact layer. n-type heavily doped n++ GaN was subjected to epitaxial growth by adopting metal-organic vapor deposition (MOCVD) and using the cured HSQ electronic photoresist as the mask to form an ohmic contact layer, wherein the doping concentration and thickness ensured that the ohmic contact layer electrically formed good ohmic contact with the channel, as shown in FIG.3e.
S6, the HSQ electronic photoresist was removed. The HSQ electronic photoresist was removed by using a BOE solution (or HF solution), as shown in FIG.3f.
S7, an active region was isolated. Isolation was performed by using an N ion injection technology, wherein the ion injection energy was 150-400 KeV ion injection, the ion injection dose was 10¹²-10¹⁴/cm², and the injection depth exceeded a buffer layer by about 50-250 nm, as shown in FIG.3g.
S8, a gate electrode dielectric was deposited. A dielectric layer (called "gate dielectric" for short) was deposited by using an atom layer deposition (ALD) technology, wherein an Al₂O₃ dielectric layer has a thickness of 1-5 nm, as shown in FIG.3h.
S9, a T-type gate electrode (called "T-type gate" for short) was fabricated. A Ni/AuT-type gate with a thickness of 50 nm/250 nm was fabricated by using secondary epitaxial ohmic contact layer as a T-type gate support layer and adopting a photoetching process and electronic beam evaporation technology, as shown in FIG.3i.
S10, a source electrode and a drain electrode were fabricated. Via a source and drain ohmic contact windowing process, the source electrode and the drain electrode were fabricated by using an electron beam evaporation technology and formed ohmic contact with the ohmic contact layer. One of the source electrode and the drain electrode can be a Ti/Au ohmic contact electrode with a thickness of 50 nm/250 nm, as shown in FIG. 3j. The knee voltage of the GaN HEMT device in this example can reach 1V or less.

### Example 2 (not constituting a part of the present invention)

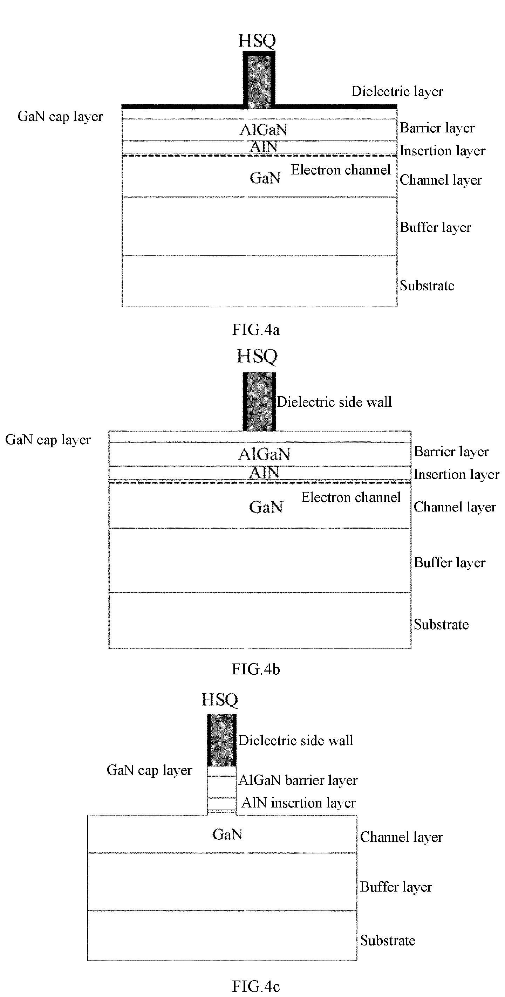

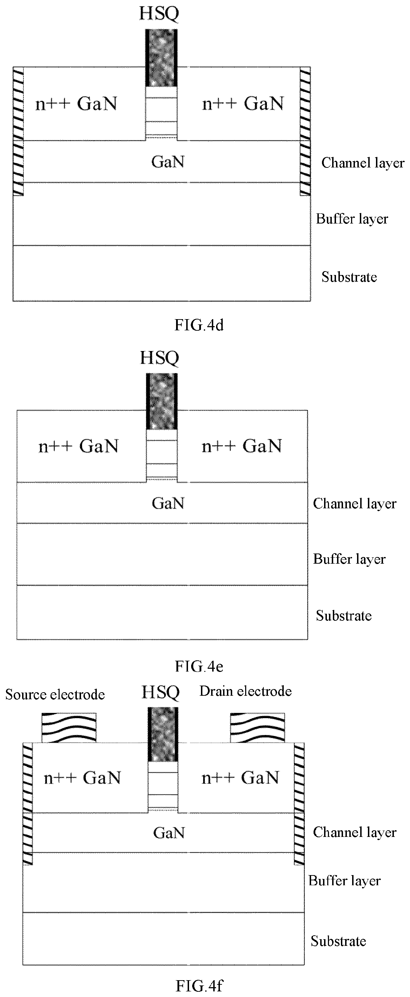

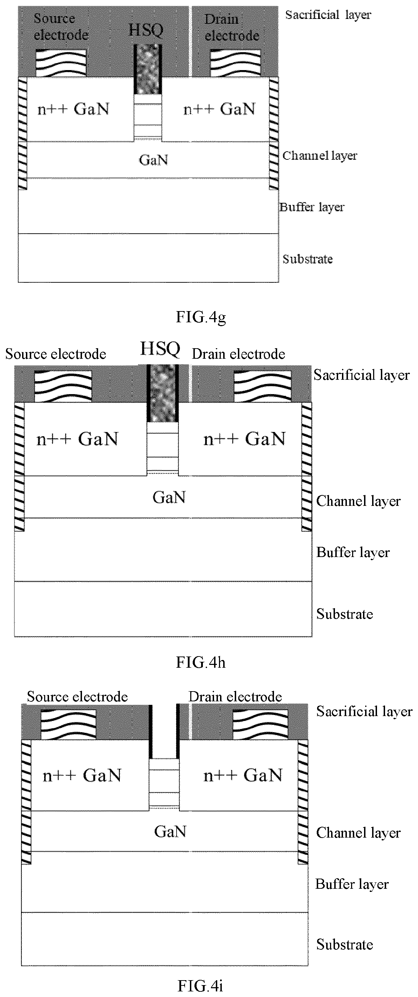

A GaN HEMT structure (hereinafter called a device for short) provided in this example is basically the same as a GaN electronic device structure as shown in FIG. 1, wherein a dielectric sacrificial layer is used as a support layer of a T-type gate layer. A fabricating method of this device is similar to that in example 1 and can include the following steps:
S1-S3, S1-S3 are similar to steps S1-S3 in the fabricating method of the device in example 1, the gate foot of the T-type gate was defined by using the HSQ electronic photoresist and then annealed and cured, as shown in FIG.3c.
S4, a dielectric layer was deposited. The dielectric layer was deposited by using an ALD technology. For example, a silicon nitride dielectric layer with a thickness of 1-5 nm can be deposited, as shown in FIG.4a.
S5, a dielectric side wall was formed. A silicon nitride dielectric layer was etched by reactive ion etch (RIE) so as to form the dielectric side wall, as shown in FIG.4b. It is worth mentioning that, the role of the dielectric side wall is that on the one hand, the stability of the HSQ electronic photoresist in the subsequent process is maintained; on the other hand, short circuit between device electrodes is prevented.
S6, a source-drain ohmic contact region was etched. The gate electrode of the source-drain ohmic contact region was etched by adopting an ICP etching technology and using the cured HSQ electronic photoresist as the mask, wherein the etching rate was controlled to 1-20 nm/min, as shown in FIG.4c.
S7, the secondary epitaxy of the ohmic contact layer was performed. n-type heavily doped n++ GaN was subjected to epitaxial growth by adopting MOCVD and using the cured HSQ electronic photoresist as the mask to form an ohmic contact layer, wherein the doping concentration and thickness ensured that the ohmic contact layer formed good ohmic contact with the channel, as shown in FIG.4d.
S8, an active region was isolated. Isolation was performed by using an N ion injection technology, wherein the ion injection energy was 150-400 KeV ion injection, the ion injection dose was 10¹²-10¹⁴/cm², and the injection depth exceeded a buffer layer by about 50-250 nm, as shown in FIG.4e.
S9, a source electrode and a drain electrode were fabricated. The source electrode and the drain electrode were fabricated by using an electron beam evaporation technology and formed ohmic contact with the ohmic contact layer. The source electrode and the drain electrode can be a Ti/Au ohm electrode with a thickness of 50 nm/250 nm, as shown in FIG. 4f.
S10, a sacrificial layer was spin-coated. The sacrificial layer was spin-coated with polyimide (PI). The spin-coating thickness ensured that the surface of the wafer was covered with patterns (that is, at least higher than the heights of the HSQ electronic photoresist, and the source electrode and the drain electrode, as shown in FIG.4g.
S11, chemical mechanical polishing (CMP). The sacrificial layer was subjected to CMP treatment to expose the cured HSQ electronic photoresist, as shown in FIG.4h.
S12, the HSQ electronic photoresist was removed. The HSQ electronic photoresist was removed with BOE solution (or HF solution), as shown in FIG.4i.
S13, a T-type gate was fabricated. A Ni/Au T-type gate with a thickness of 50 nm/250 nm was fabricated by using the sacrificial layer as the support layer and adopting a photoetching process and electron beam evaporation technology, as shown in FIG.4J.
S14, the sacrificial layer was removed. The sacrificial layer was removed by using an organic solvent or plasma Ashing, so as to realize the T-gate structure that was subjected to spatial isolation from the heavily doped ohmic contact layer by utilizing air, as shown in FIG.4k. The knee voltage of the GaN HEMT device in this example can reach 1 V or less.

The device provided in this example is a depletion-mode device, but a dielectric layer is arranged between the gate electrode and the cap layer so that the device becomes an enhanced device.

### Example 3

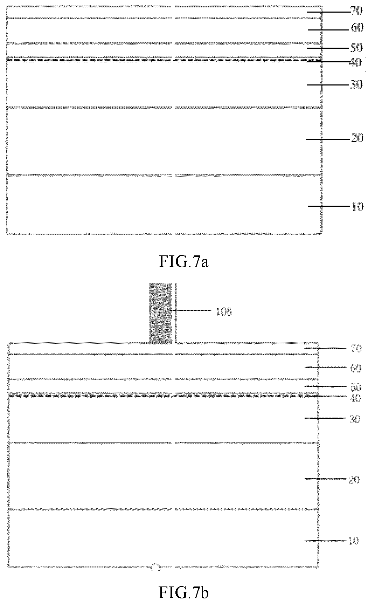

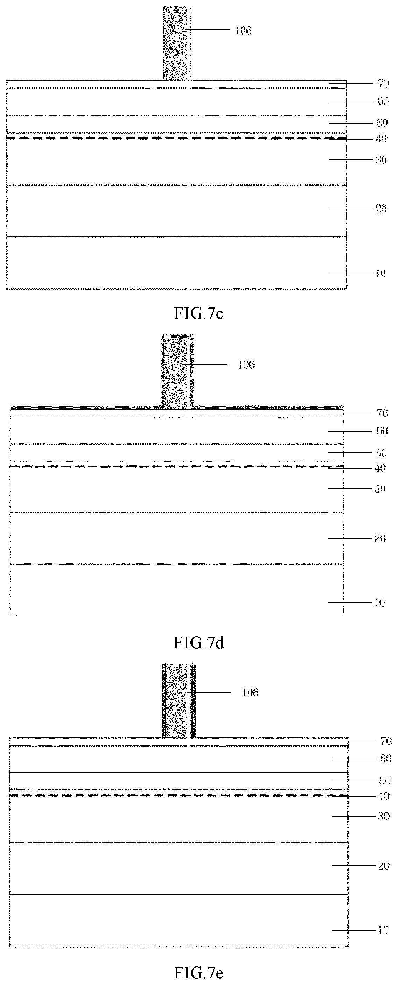

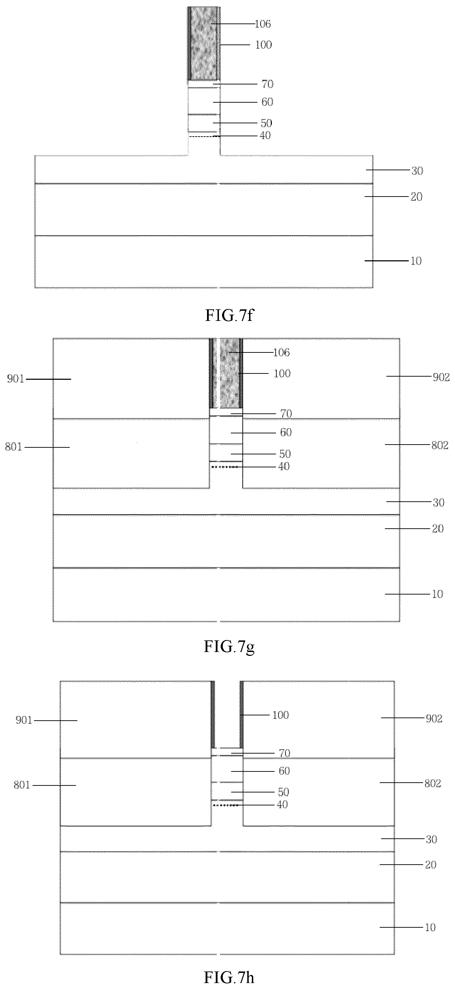

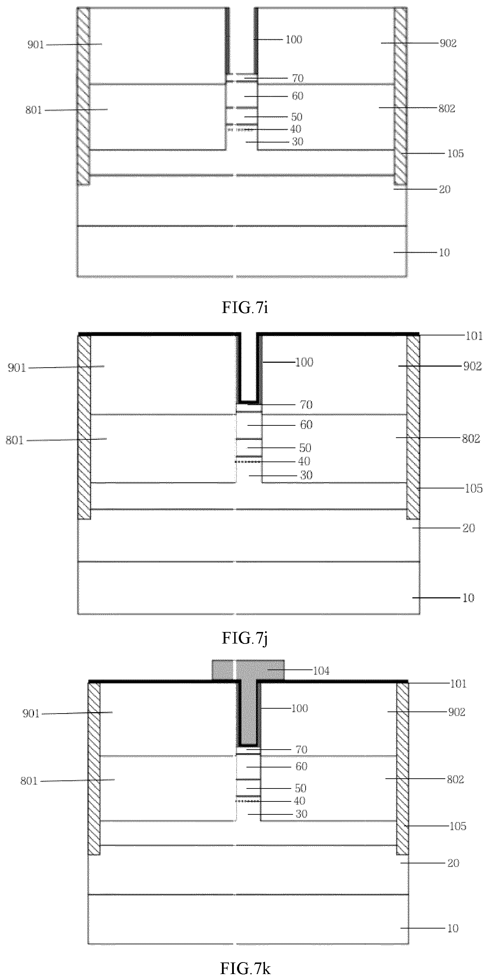

A fabricating method of a high-electron-mobility transistor structure as shown in FIG.5 provided in this example can include the following steps:
Step 1), successively epitaxially growing a GaN buffer layer 20 with a thickness of 1500 nm, a GaN first semiconductor layer 30 with a thickness of 150 nm, an AlN insertion layer 50 with a thickness of 1 nm, an AlGaN second semiconductor layer 60 with a thickness of 5 nm and a GaN cap layer 70 with a thickness of 2 nm on a sapphire substrate 10, wherein a two-dimensional electron gas channel 40 was formed below the surface of the GaN first semiconductor layer 30 close to the surface of the AlN insertion layer 50, as shown in FIG.7a;
Step 2), defining the size, namely, the gate electrode length *L*_{G} ≈ 50-500 nm, of the gate foot of the T-type gate on the epitaxial structure by using HSQ electronic photoresist 106, as shown in FIG.7b;
Step 3), the HSQ electronic photoresist 106 was cured by an annealing process, wherein the annealing temperature was about 400°C, as shown in FIG.7c;
Step 4), a SiN sidewall dielectric layer with a thickness of 5 nm was deposited on the device surface formed in step 3) by using a low pressure chemical vapor deposition (LPCVD), as shown in FIG.7d, and then the GaN cap layer 70 and the SiN sidewall dielectric layer on the upper surface of the HSQ electronic photoresist were etched away by using a self-aligned etching technology, as shown in FIG.7e;
Step 5), a source electrode contact region and a drain electrode contact region were etched by using the cured HSQ electronic photoresist 106 as the mask and using ICP, and the GaN cap layers 70, the AlGaN second semiconductor layers 60, the AlN insertion layers 50 and the partially thickness of GaN first semiconductor layers 30 in the source electrode contact region and the drain electrode contact region were removed, so that the region of the GaN first semiconductor layer 30 corresponding to the gate electrode 104 was formed into a bulge portion, the AlN insertion layers 50, the AlGaN second semiconductor layers 60 and the GaN cap layers 70 of the rest part were distributed on the bulge portion, as shown in FIG. 7f;
Step 6), an n-type heavily doped GaN material layers were epitaxially grown in the source electrode contact region and the drain electrode contact region which were subjected to etching by continuing to use the cured HSQ electronic photoresist 106 as the mask and adopting the MOCVD technology to form a first heavily doped region 801 and a second doped region 802, the thicknesses and doping concentrations of the first heavily doped region 801 and the second doped region 802 (i.e., the surfaces of the heavily doped region 801 and the second doped region 802 were higher than the surface of a two-dimensional electron gas channel 40) ensured that the first doped region and the second doped region formed good ohmic contact with the two-dimensional electron gas channel 40, then high resistance GaN material layers were epitaxially grown on the first heavily doped region 801 and the second doped region 802 to form a first high resistance region 901 and a second high resistance region 902, as shown in FIG.7g;
Step 7), the HSQ electronic photoresist 106 was removed by using BOE solution or HF solution, as shown in FIG.7h;
Step 8), the isolation region 105 of the active region was formed at both sides of the epitaxial structure by using an N ion injection technology, wherein the N ion injection energy was 100-400keV, the N ion injection dose was 10¹²-10¹⁵/cm², and the injection depth exceeded the GaN buffer layer 20by about 50-250 nm, as shown in FIG.7i;
Step 9), a Al₂O₃ dielectric layer 101 with a thickness of 1 nm was deposited on the surface of the device formed in step 8) by using ALD, as shown in FIG.7j;
Step 10),the gate electrode 104was fabricated by using the first high resistance region 901 and the second high resistance region 902 as the support layers of the gate cap of the gate electrode 104, wherein the gate electrode 104 was made of Ni/Au, and had a thickness of 50nm/250nm, as shown in FIG.7k;
Step 11),windows were formed on the Al₂O₃ dielectric layer 101, the first high resistance region 901 and the second high resistance region 902, and the source electrodes 102 and the drain electrodes 103 were fabricated in the windows by using use the electron beam evaporation technology, wherein the source electrode and the drain electrode were made of Ti/Au and had a thickness of 50nm/250nm, and the fabrication of the high-electron-mobility transistor structure was completed, as shown in FIG. 5.

It is noted that the process steps in this example can be adjusted according to practical situations, as long as the final device can be implemented, which is well-known to those skilled in the art, and cannot be described in detail.

### Example 4

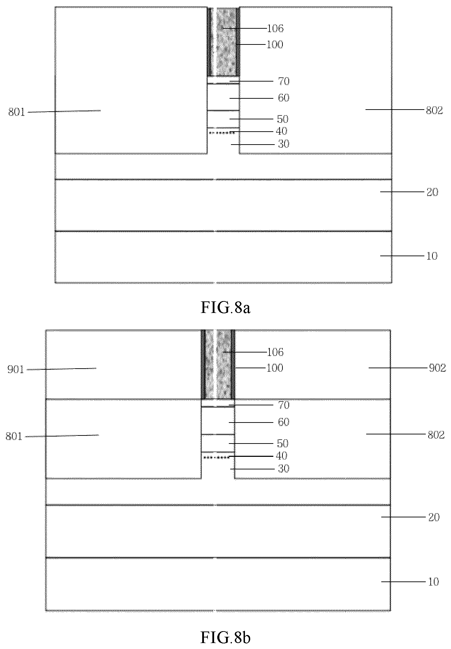

A fabricating method of a high-electron-mobility transistor structure as shown in FIG.5 provided in this example is basically similar to that in example 1 except that:
Step 6), an n-type heavily doped GaN material layer was epitaxially grown in the source electrode contact region and the drain electrode contact region which were subjected to etching by using the cured HSQ electron photoresist 106 as the mask to form the first heavily doped region 801 and the second heavily doped region 802, the thicknesses and doping concentrations of the first heavily doped region 801 and the second doped region 802 ensured that the first heavily doped region and the second doped region formed good ohmic contact with the two-dimensional electron gas channel 40, as shown in FIG.8, then the n-type heavily doped layer GaN materials were transformed at the specified depths of the first heavily doped region 801 and the second heavily doped region 802 from the surfaces of the first heavily doped region 801 and the second heavily doped region 802 to the inside of the first heavily doped region 801 and the second heavily doped region 802 into the first high resistance region 901 and the second high resistance region 902, wherein the specified depth was higher than the surface of the two-dimensional electron gas channel 40, as shown in FIG.8b.

In the above examples the self-alignment process and secondary epitaxy technology are adopted, and the heavily doped layer and high resistance layer composite is used as the support layer, and the T-type gate is directly built between the source electrode and the drain electrode, thereby realizing a high-electron-mobility transistor structure with short channel, near-full gate control, no access region series resistance and low parasitic effect, and improving the frequency characteristics and output efficiency of the device while effectively reducing the knee voltage of the device and improving the linearity of the device. Meanwhile, the high-electron-mobility transistor structure provided by the present application adopts the thin barrier-based heterojunction epitaxial structure, so as to fabricate the enhanced device fabrication without the groove gate etching process. Furthermore, the thin barrier-based material structure makes the device have large transconductance, which is conducive to improving the gain of the RF power amplifier.

Moreover, the high-electron-mobility transistor structure provided in the examples is also applicable to GaN HEMT devices with a back barrier structure or other back structures, as well as GaN HEMT devices with various polarity planes, including a Ga surface, an N surface, etc.

## Claims

1. A high-electron-mobility transistor structure, comprising:
an epitaxial structure, comprising a first semiconductor layer made from GaN (30) and a second semiconductor layer made from AlGaN (60), the first and second semiconductor layer being part of a heterostructure comprising a heterojunction, a carrier channel being formed in the first semiconductor layer at the heterojunction; and a source electrode (102), a drain electrode (103) and a gate electrode (104) which are matched with the epitaxial structure, the source electrode (102) being electrically connected with the drain electrode (103) through the carrier channel; wherein, a coincidence rate between the orthographic projection of the gate foot of the gate electrode (104) on the first semiconductor layer and the orthographic projection of the second semiconductor layer on the first semiconductor layer is more than 80%; wherein the epitaxial structure further comprises a ohmic contact layer, the ohmic contact layer is in contact with the carrier channel, both the source electrode and the drain electrode are arranged on the ohmic contact layer and form ohmic contact with the ohmic contact layer; wherein the ohmic contact layer comprises a heavily doped region and a high resistance region, the heavily doped region is arranged on the heterostructure and forms ohmic contact with the carrier channel, the source electrode (102) and the drain electrode (103) form ohmic contact with the heavily doped region, the high resistance region is arranged on the heavily doped region, the source electrode (102) is isolated from the gate electrode (104) by the high resistance region, and the drain electrode (103) is isolated from the gate electrode (104) by the high resistance region; wherein the upper surface of the heavily doped region is higher than the surface of the carrier channel; and, the heavily doped region comprises a first heavily doped region (801) matched with the source electrode (102) and a second heavily doped region (802) matched with the drain electrode (103), the first heavily doped region (801) and the second heavily doped region (802) are made of n-type heavily doped GaN materials, the first heavily doped region (801) and the second heavily doped region (802) are respectively located at two sides of the second semiconductor layer, the high resistance region comprises a first high resistance region (901) matched with the source electrode (102) and a second high resistance region (902) matched with the drain electrode (103), and at least partial regions of the source electrode (102) and the drain electrode (103) penetrate through the first high resistance region (901) and the second high resistance region (902), respectively, and then are in ohmic contact with the first heavily doped region (801) and the second heavily doped region (802), respectively; and **characterized in that** the first high resistance region (901) and the second high resistance region (902) are made of high resistance GaN materials.

2. The high-electron-mobility transistor structure according to claim 1, wherein the carrier channel is distributed in a region covered by the orthographic projection of the gate electrode (104) on the epitaxial structure.

3. The high-electron-mobility transistor structure according to claim 1, wherein the carrier channel is a two-dimensional electron gas channel (40), the second semiconductor layer is arranged on the first semiconductor layer.

4. The high-electron-mobility transistor structure according to claim 3, wherein the first semiconductor layer comprises a first region and a second region, a bulge portion is formed in the first region, the second semiconductor layer is arranged on the bulge portion, the first heavily doped region and the second heavily doped region are arranged on the second region and distributed at two sides of the bulge portion.

5. The high-electron-mobility transistor structure according to claim 1, wherein a GaN cap layer is distributed between the gate electrode (104) and the second semiconductor layer;
and/or, the epitaxial structure further comprises an AlN insertion layer distributed between the first semiconductor layer and the second semiconductor layer.

6. The high-electron-mobility transistor structure according to claim 5, wherein the epitaxial structure comprises a Ga polar surface or an N polar surface.

7. The high-electron-mobility transistor structure according to claim 1, wherein the gate electrode (104) comprises a gate cap and the gate foot, wherein the gate cap is arranged on the high resistance region and supported by the high resistance region, the gate foot is arranged in the epitaxial structure, and the carrier channel is distributed right under the gate foot;
and/or, the size of the gate cap in the direction of a source-drain channel is larger than that of the gate foot in the direction of the source-drain channel, and the size of the gate foot in the direction of the source-drain channel is smaller than the length of the carrier channel; preferably, the gate electrode (104) is a T-type gate.

8. The high-electron-mobility transistor structure according to claim 1, wherein a dielectric layer is arranged between the gate electrode (104) and the heterojunction; and/or, the dielectric layer is also used for electrically isolating the gate electrode (104) and the high resistance region;
and/or, the dielectric layer also extends and covers the surface of the epitaxial structure, and the source electrode (102) and the drain electrode (103) are matched with the epitaxial structure through corresponding windows formed on the dielectric layer.

9. The high-electron-mobility transistor structure according to claim 1, further comprising an isolation region formed in the epitaxial structure and used for isolating an active region.

10. The high-electron-mobility transistor structure according to claim 1, wherein the high-electron-mobility transistor structure comprises a nitrogen polar high-electron-mobility transistor (HEMT) device structure;
and/or, the high-electron-mobility structure is of a depletion-mode device structure or an enhancement-mode device structure;
and/or, the high-electron-mobility structure further comprises a substrate where the epitaxial structure is formed;
and/or, the epitaxial structure further comprises a GaN buffer layer distributed between the substrate and the first semiconductor layer.

11. A fabricating method of a high-electron-mobility transistor structure, comprising:
a step of fabricating
an epitaxial structure, the epitaxial structure comprising a first semiconductor layer made from GaN (30) and a second semiconductor layer made from AlGaN (60), the first and second semiconductor layer being part of a heterostructure comprising a heterojunction, and a carrier channel being formed in the first semiconductor layer at the heterojunction, and
a step of fabricating a source electrode (102), a drain electrode (103) and a gate electrode (104) which are matched with the epitaxial structure, the source electrode (102) being electrically connected with the drain electrode (103) through the carrier channel;
wherein, the step of fabricating the gate electrode (104) comprises: the size of the gate foot of the gate electrode (104) is set to meet the following conditions: a coincidence rate between the orthographic projection of the gate foot of the gate electrode (104) on the first semiconductor layer and the orthographic projection of the second semiconductor layer on the first semiconductor layer is more than 80%;
wherein the fabricating method specifically comprises:
successively growing a first semiconductor layer and a second semiconductor layer on a substrate;
arranging a mask on the gate electrode region of the second semiconductor layer, wherein the radial size of the mask is consistent to that of the gate foot;
etching to remove the region of the second semiconductor layer that is not protected by the mask, wherein the etching depth is a depth of reaching the surface of the first semiconductor layer or entering the first semiconductor layer;
at least growing ohmic contact layers on the source electrode region and the drain electrode region of the first semiconductor layer, and allowing the height of the surface of the second semiconductor layer to be below the height of the surface of the ohmic contact layer, and contacting the ohmic contact layer with the carrier channel, wherein the ohmic contact layer comprises a heavily doped region and a high resistance region;
fabricating a gate electrode (104) on the second semiconductor layer after the mask is removed, and respectively fabricating the source electrode (102) and the drain electrode (103) on the source electrode region and the drain electrode region of the ohmic contact layer, and allowing the source electrode (102) and the drain electrode (103) to form ohmic contact with the ohmic contact layer;
wherein the fabricating method further comprises:
fabricating the heavily doped region and the high resistance region on the heterostructure, and arranging the high resistance region on the heavily doped region, and allowing the heavily doped region and the carrier channel to form ohmic contact, thereby forming the epitaxial structure; and
allowing both the source electrode (102) and the drain electrode (103) to form ohmic contact with the heavily doped region, and allowing the source electrode (102) to be isolated from the gate electrode (104) by the high resistance region and allowing the drain electrode (102) to be isolated from the gate electrode (104) by the high resistance region; the carrier channel at the heterojunction being distributed in a region covered by the orthographic projection of the gate electrode (104) on the epitaxial structure;
wherein the upper surface of the heavily doped region is higher than the surface of the carrier channel;
and, the heavily doped region comprises a first heavily doped region (801) matched with the source electrode (102) and a second heavily doped region (802) matched with the drain electrode (103), the first heavily doped region (801) and the second heavily doped region (802) are made of n-type heavily doped GaN materials, the first heavily doped region (801) and the second heavily doped region (802) are respectively located at two sides of the second semiconductor layer, the high resistance region comprises a first high resistance region (901) matched with the source electrode (102) and a second high resistance region (902) matched with the drain electrode (103), and at least partial regions of the source electrode (102) and the drain electrode (103) penetrate through the first high resistance region (901) and the second high resistance region (902), respectively, and then are in ohmic contact with the first heavily doped region (801) and the second heavily doped region (802), respectively; and
**characterized in that** the first high resistance region (901) and the second high resistance region (902) are made of high resistance GaN materials.

12. The fabricating method according to claim 11, further comprising: after the ohmic contact layer is grown, removing the mask and then forming a continuous dielectric layer on the ohmic contact layer and the second semiconductor layer, then fabricating the gate electrode (104) on the dielectric layer, and forming a window on the dielectric layer, and fabricating the source electrode (102) and the drain electrode (103) in the window.

13. The fabricating method according to claim 11, specifically comprising:
growing a first semiconductor layer and a second semiconductor layer on a substrate; arranging a mask on a region of the surface of the second semiconductor layer corresponding to the gate electrode (104), etching the second semiconductor layer and the first semiconductor layer by utilizing the mask until the source electrode contact region and the drain electrode contact region of the second semiconductor layer are both removed, and the source electrode contact region and the drain electrode contact region of the first semiconductor layer are partially removed, so that the region of the first semiconductor layer corresponding to the gate electrode (104) forms a bulge portion, and the rest part of the second semiconductor layer is distributed on the bulge portion;
growing the heavily doped layers on the rest parts of the source electrode contact region and the drain electrode contact region of the first semiconductor layer and allowing the upper surface of the heavily doped region to be higher than the surface of the carrier channel, then growing a high resistance layer on the heavily doped layer to form a high resistance region, thereby forming the epitaxial structure,
or, growing the heavily doped layers on the rest parts of the source electrode contact region and the drain electrode contact region of the first semiconductor layer and then transforming a semiconductor material at a specified depth from the surface of the heavily doped layer to the inside of the heavily doped layer into a high resistance material so as to form a high resistance region and a heavily doped region in the heavily doped layer, and allowing the specified depth to be higher than the surface of the carrier channel so as to form the epitaxial structure; and
removing the mask, and fabricating the source electrode (102), the drain electrode (103) and the gate electrode (104).

14. The fabricating method according to claim 11 or 13, specifically comprising:
forming a dielectric layer between the gate electrode (104) and the heterojunction; and/or, the gate electrode (104) comprising a gate foot and a gate cap which are successively distributed in a direction away from the second semiconductor layer, wherein the radial size of the gate foot is smaller than or equal to that of the gate cap;
preferably, the gate electrode (104) comprises a T-type gate;
and/or, the fabricating method specifically further comprises: forming a side wall dielectric layer between the gate foot of the gate electrode (104) and the high resistance region;
and/or, the fabricating method specifically further comprises: forming a GaN buffer layer between the substrate and the first semiconductor layer;
and/or, the fabricating method specifically further comprises: forming an isolation region isolating an active region in the epitaxial structure.

15. Use of the high-electron-mobility transistor structure according to any one of claims 1-10 in fabricating a power amplifier, a radio frequency device, a communication device or an electronic device.

16. A power amplifier, comprising the high-electron-mobility transistor structure according to any one of claims 1-10.

17. The power amplifier according to claim 16, comprising a power amplifier with a radio frequency wave band, a millimeter wave band or a terahertz wave band.

## Patentansprüche

1. Eine Hoch-Elektronenbeweglichkeits-Transistorstruktur, umfassend:
eine Epitaxiestruktur, umfassend eine erste aus GaN hergestellte Halbleiterschicht (30) und eine zweite aus AlGaN hergestellte Halbleiterschicht (60), wobei die erste und die zweite Halbleiterschicht Teil einer Heterostruktur mit einem Heteroübergang sind, wobei in der ersten Halbleiterschicht am Heteroübergang ein Trägerkanal ausgebildet ist; und eine Quellelektrode (102), eine Drain-Elektrode (103) und eine Gate-Elektrode (104), die der Epitaxiestruktur zugeordnet sind, wobei die Quellelektrode (102) elektrisch mit der Drain-Elektrode (103) über den Trägerkanal verbunden ist; wobei eine Übereinstimmungsrate zwischen der orthogonalen Projektion des Gatefußes der Gate-Elektrode (104) auf die erste Halbleiterschicht und der orthogonalen Projektion der zweiten Halbleiterschicht auf die erste Halbleiterschicht größer als 80 % ist; wobei die Epitaxiestruktur ferner eine ohmsche Kontaktschicht umfasst, die ohmsche Kontaktschicht steht in Kontakt mit dem Trägerkanal, sowohl die Quellelektrode als auch die Drain-Elektrode sind auf der ohmschen Kontaktschicht angeordnet und bilden ohmschen Kontakt mit der ohmschen Kontaktschicht; wobei die ohmsche Kontaktschicht einen stark dotierten Bereich und einen hochohmigen Bereich umfasst, der stark dotierte Bereich ist auf der Heterostruktur angeordnet und bildet ohmschen Kontakt mit dem Trägerkanal, die Quellelektrode (102) und die Drain-Elektrode (103) bilden ohmschen Kontakt mit dem stark dotierten Bereich, der hochohmige Bereich ist auf dem stark dotierten Bereich angeordnet, die Quellelektrode (102) ist durch den hochohmigen Bereich von der Gate-Elektrode (104) isoliert, und die Drain-Elektrode (103) ist durch den hochohmigen Bereich von der Gate-Elektrode (104) isoliert; wobei die obere Oberfläche des stark dotierten Bereichs höher liegt als die Oberfläche des Trägerkanals; und wobei der stark dotierte Bereich einen ersten stark dotierten Bereich (801), der der Quellelektrode (102) zugeordnet ist, und einen zweiten stark dotierten Bereich (802), der der Drain-Elektrode (103) zugeordnet ist, umfasst, wobei der erste stark dotierte Bereich (801) und der zweite stark dotierte Bereich (802) aus n-leitend stark dotiertem GaN-Material hergestellt sind, wobei der erste stark dotierte Bereich (801) und der zweite stark dotierte Bereich (802) jeweils auf zwei Seiten der zweiten Halbleiterschicht angeordnet sind, wobei der hochohmige Bereich einen ersten hochohmigen Bereich (901), der der Quellelektrode (102) zugeordnet ist, und einen zweiten hochohmigen Bereich (902), der der Drain-Elektrode (103) zugeordnet ist, umfasst, und wobei zumindest Teilbereiche der Quellelektrode (102) und der Drain-Elektrode (103) jeweils den ersten hochohmigen Bereich (901) bzw. den zweiten hochohmigen Bereich (902) durchdringen und dann jeweils in ohmschem Kontakt mit dem ersten stark dotierten Bereich (801) bzw. dem zweiten stark dotierten Bereich (802) stehen; und **dadurch gekennzeichnet, dass** der erste hochohmige Bereich (901) und der zweite hochohmige Bereich (902) aus hochohmigem GaN-Material bestehen.

2. Hoch-Elektronenbeweglichkeits-Transistorstruktur nach Anspruch 1, **dadurch gekennzeichnet, dass** der Trägerkanal in einem Bereich verteilt ist, der durch die orthogonale Projektion der Gate-Elektrode (104) auf die Epitaxiestruktur abgedeckt ist.

3. Hoch-Elektronenbeweglichkeits-Transistorstruktur nach Anspruch 1, **dadurch gekennzeichnet, dass** der Trägerkanal ein zweidimensionaler Elektronengas-Kanal (40) ist, wobei die zweite Halbleiterschicht auf der ersten Halbleiterschicht angeordnet ist.

4. Hoch-Elektronenbeweglichkeits-Transistorstruktur nach Anspruch 3, **dadurch gekennzeichnet, dass** die erste Halbleiterschicht einen ersten Bereich und einen zweiten Bereich umfasst, wobei in dem ersten Bereich ein Vorsprungsteil ausgebildet ist, die zweite Halbleiterschicht auf dem Vorsprungsteil angeordnet ist, und der erste stark dotierte Bereich und der zweite stark dotierte Bereich auf dem zweiten Bereich angeordnet und auf zwei Seiten des Vorsprungsteils verteilt sind.

5. Hoch-Elektronenbeweglichkeits-Transistorstruktur nach Anspruch 1, **dadurch gekennzeichnet, dass** eine GaN-Deckschicht zwischen der Gate-Elektrode (104) und der zweiten Halbleiterschicht verteilt ist;
und/oder, dass die Epitaxiestruktur ferner eine zwischen der ersten Halbleiterschicht und der zweiten Halbleiterschicht verteilte AlN-Einfügungsschicht umfasst.

6. Hoch-Elektronenbeweglichkeits-Transistorstruktur nach Anspruch 5, **dadurch gekennzeichnet, dass** die Epitaxiestruktur eine Ga-polare Oberfläche oder eine N-polare Oberfläche umfasst.

7. Hoch-Elektronenbeweglichkeits-Transistorstruktur nach Anspruch 1, **dadurch gekennzeichnet, dass** die Gate-Elektrode (104) eine Gate-Kappe und einen Gate-Fuß umfasst, wobei die Gate-Kappe auf dem hochohmigen Bereich angeordnet und durch den hochohmigen Bereich gestützt ist, der Gate-Fuß in der Epitaxiestruktur angeordnet ist und der Trägerkanal sich unmittelbar unter dem Gate-Fuß befindet;
und/oder, dass die Größe der Gate-Kappe in Richtung eines Source-Drain-Kanals größer ist als die des Gate-Fußes in Richtung des Source-Drain-Kanals, und dass die Größe des Gate-Fußes in Richtung des Source-Drain-Kanals kleiner ist als die Länge des Trägerkanals; vorzugsweise ist die Gate-Elektrode (104) ein T-förmiges Gate.

8. Hoch-Elektronenbeweglichkeits-Transistorstruktur nach Anspruch 1, wobei zwischen der Gate-Elektrode (104) und dem Heteroübergang eine dielektrische Schicht angeordnet ist, und/oder wobei die dielektrische Schicht auch zur elektrischen Isolierung der Gate-Elektrode (104) und des hochohmigen Bereichs dient;
und/oder, dass die dielektrische Schicht sich ferner erstreckt und die Oberfläche der Epitaxiestruktur abdeckt, und dass die Quellelektrode (102) und die Drain-Elektrode (103) der Epitaxiestruktur durch entsprechende auf der dielektrischen Schicht gebildete Öffnungen zugeordnet sind.

9. Hoch-Elektronenbeweglichkeits-Transistorstruktur nach Anspruch 1, ferner umfassend einen in der Epitaxiestruktur gebildeten Isolationsbereich, der zur Isolierung eines aktiven Bereichs dient.

10. Hoch-Elektronenbeweglichkeits-Transistorstruktur nach Anspruch 1, **dadurch gekennzeichnet, dass** die Hoch-Elektronenbeweglichkeits-Transistorstruktur eine Stickstoff-polare Hoch-Elektronenbeweglichkeits-Transistor-(HEMT)-Baustruktur umfasst;
und/oder, dass die Hoch-Elektronenbeweglichkeits-Struktur eine Baustruktur im Depletion-Modus oder eine Baustruktur im Enhancement-Modus ist;
und/oder, dass die Hoch-Elektronenbeweglichkeits-Struktur ferner ein Substrat umfasst, auf dem die Epitaxiestruktur gebildet ist;
und/oder, dass die Epitaxiestruktur ferner eine zwischen dem Substrat und der ersten Halbleiterschicht verteilte GaN-Pufferschicht umfasst.

11. Ein Herstellungsverfahren einer Hoch-Elektronenbeweglichkeits-Transistorstruktur, umfassend:
einen Schritt des Herstellens
einer Epitaxiestruktur, wobei die Epitaxiestruktur eine erste aus GaN hergestellte Halbleiterschicht (30) und eine zweite aus AlGaN hergestellte Halbleiterschicht (60) umfasst, wobei die erste und die zweite Halbleiterschicht Teil einer Heterostruktur mit einem Heteroübergang sind, und in der ersten Halbleiterschicht am Heteroübergang ein Trägerkanal ausgebildet ist, und
einen Schritt des Herstellens einer Quellelektrode (102), einer Drain-Elektrode (103) und einer Gate-Elektrode (104), die der Epitaxiestruktur zugeordnet sind, wobei die Quellelektrode (102) elektrisch mit der Drain-Elektrode (103) über den Trägerkanal verbunden ist;
wobei der Schritt des Herstellens der Gate-Elektrode (104) umfasst: die Größe des Gate-Fußes der Gate-Elektrode (104) ist so eingestellt, dass die folgenden Bedingungen erfüllt sind: eine Übereinstimmungsrate zwischen der orthogonalen Projektion des Gate-Fußes der Gate-Elektrode (104) auf die erste Halbleiterschicht und der orthogonalen Projektion der zweiten Halbleiterschicht auf die erste Halbleiterschicht beträgt mehr als 80 %;
wobei das Herstellungsverfahren insbesondere umfasst:
aufeinanderfolgendes Aufwachsen einer ersten Halbleiterschicht und einer zweiten Halbleiterschicht auf einem Substrat;
Anordnen einer Maske auf dem Gate-Elektrodenbereich der zweiten Halbleiterschicht, wobei die radiale Größe der Maske mit der des Gate-Fußes übereinstimmt;
Ätzen zum Entfernen des Bereichs der zweiten Halbleiterschicht, der nicht durch die Maske geschützt ist, wobei die Ätztiefe eine Tiefe ist, die die Oberfläche der ersten Halbleiterschicht erreicht oder in die erste Halbleiterschicht hineinreicht;
mindestens Aufwachsen ohmscher Kontaktschichten auf dem Quellelektrodenbereich und dem Drain-Elektrodenbereich der ersten Halbleiterschicht und Anordnen der Höhe der Oberfläche der zweiten Halbleiterschicht unterhalb der Höhe der Oberfläche der ohmschen Kontaktschicht, und Inkontaktbringen der ohmschen Kontaktschicht mit dem Trägerkanal, wobei die ohmsche Kontaktschicht einen stark dotierten Bereich und einen hochohmigen Bereich umfasst;
Herstellen einer Gate-Elektrode (104) auf der zweiten Halbleiterschicht nach dem Entfernen der Maske sowie jeweils Herstellen der Quellelektrode (102) und der Drain-Elektrode (103) auf dem Quellelektrodenbereich und dem Drain-Elektrodenbereich der ohmschen Kontaktschicht, wodurch die Quellelektrode (102) und die Drain-Elektrode (103) ohmschen Kontakt mit der ohmschen Kontaktschicht bilden;
wobei das Herstellungsverfahren ferner umfasst:
Herstellen des stark dotierten Bereichs und des hochohmigen Bereichs auf der Heterostruktur,
und Anordnen des hochohmigen Bereichs auf dem stark dotierten Bereich, und Ermöglichen, dass der stark dotierte Bereich und der Trägerkanal ohmschen Kontakt bilden, wodurch die Epitaxiestruktur gebildet wird; und
Ermöglichen, dass sowohl die Quellelektrode (102) als auch die Drain-Elektrode (103) ohmschen Kontakt mit dem stark dotierten Bereich bilden, und dass die Quellelektrode (102) durch den hochohmigen Bereich von der Gate-Elektrode (104) isoliert ist und dass die Drain-Elektrode (102) durch den hochohmigen Bereich von der Gate-Elektrode (104) isoliert ist; wobei der Trägerkanal am Heteroübergang in einem Bereich verteilt ist, der durch die orthogonale Projektion der Gate-Elektrode (104) auf die Epitaxiestruktur abgedeckt ist;
wobei die obere Oberfläche des stark dotierten Bereichs höher liegt als die Oberfläche des Trägerkanals;
und wobei der stark dotierte Bereich einen ersten stark dotierten Bereich (801), der der Quellelektrode (102) zugeordnet ist, und einen zweiten stark dotierten Bereich (802), der der Drain-Elektrode (103) zugeordnet ist, umfasst, wobei der erste stark dotierte Bereich (801) und der zweite stark dotierte Bereich (802) aus n-leitend stark dotiertem GaN-Material hergestellt sind, wobei der erste stark dotierte Bereich (801) und der zweite stark dotierte Bereich (802) jeweils auf zwei Seiten der zweiten Halbleiterschicht angeordnet sind, wobei der hochohmige Bereich einen ersten hochohmigen Bereich (901), der der Quellelektrode (102) zugeordnet ist, und einen zweiten hochohmigen Bereich (902), der der Drain-Elektrode (103) zugeordnet ist, umfasst, und wobei zumindest Teilbereiche der Quellelektrode (102) und der Drain-Elektrode (103) jeweils den ersten hochohmigen Bereich (901) bzw. den zweiten hochohmigen Bereich (902) durchdringen und dann jeweils in ohmschem Kontakt mit dem ersten stark dotierten Bereich (801) bzw. dem zweiten stark dotierten Bereich (802) stehen; und
**dadurch gekennzeichnet, dass** der erste hochohmige Bereich (901) und der zweite hochohmige Bereich (902) aus hochohmigem GaN-Material bestehen.

12. Herstellungsverfahren nach Anspruch 11, ferner umfassend: nach dem Aufwachsen der ohmschen Kontaktschicht Entfernen der Maske und anschließendes Bilden einer durchgehenden dielektrischen Schicht auf der ohmschen Kontaktschicht und der zweiten Halbleiterschicht, danach Herstellen der Gate-Elektrode (104) auf der dielektrischen Schicht, und Bilden eines Fensters in der dielektrischen Schicht, und Herstellen der Quellelektrode (102) und der Drain-Elektrode (103) in dem Fenster.

13. Herstellungsverfahren nach Anspruch 11, insbesondere umfassend:
Aufwachsen einer ersten Halbleiterschicht und einer zweiten Halbleiterschicht auf einem Substrat; Anordnen einer Maske auf einem Bereich der Oberfläche der zweiten Halbleiterschicht, der der Gate-Elektrode (104) entspricht, Ätzen der zweiten Halbleiterschicht und der ersten Halbleiterschicht unter Verwendung der Maske, bis sowohl der Quellelektroden-Kontaktbereich als auch der Drain-Elektroden-Kontaktbereich der zweiten Halbleiterschicht entfernt und die Quellelektroden-Kontaktregion und die Drain-Elektroden-Kontaktregion der ersten Halbleiterschicht teilweise entfernt sind, sodass der Bereich der ersten Halbleiterschicht, der der Gate-Elektrode (104) entspricht, einen Vorsprungsteil bildet, und der verbleibende Teil der zweiten Halbleiterschicht auf dem Vorsprungsteil verteilt ist;
Aufwachsen der stark dotierten Schichten auf den verbleibenden Teilen des Quellelektroden-Kontaktbereichs und des Drain-Elektroden-Kontaktbereichs der ersten Halbleiterschicht und Ermöglichen, dass die obere Oberfläche des stark dotierten Bereichs höher liegt als die Oberfläche des Trägerkanals, danach Aufwachsen einer hochohmigen Schicht auf der stark dotierten Schicht zur Bildung eines hochohmigen Bereichs, wodurch die Epitaxiestruktur gebildet wird,
oder, Aufwachsen der stark dotierten Schichten auf den verbleibenden Teilen des Quellelektroden-Kontaktbereichs und des Drain-Elektroden-Kontaktbereichs der ersten Halbleiterschicht und anschließendes Umwandeln eines Halbleitermaterials in einer vorgegebenen Tiefe von der Oberfläche der stark dotierten Schicht bis ins Innere der stark dotierten Schicht in ein hochohmiges Material, um einen hochohmigen Bereich und einen stark dotierten Bereich in der stark dotierten Schicht zu bilden, und Ermöglichen, dass die vorgegebene Tiefe höher liegt als die Oberfläche des Trägerkanals, um die Epitaxiestruktur zu bilden; und
Entfernen der Maske sowie Herstellen der Quellelektrode (102), der Drain-Elektrode (103) und der Gate-Elektrode (104).

14. Herstellungsverfahren nach Anspruch 11 oder 13, insbesondere umfassend:
Bildung einer dielektrischen Schicht zwischen der Gate-Elektrode (104) und dem Heteroübergang; und/oder, die Gate-Elektrode (104) umfasst einen Gate-Fuß und eine Gate-Kappe umfasst, die in einer Richtung von der zweiten Halbleiterschicht weg aufeinanderfolgend verteilt sind, wobei die radiale Größe des Gate-Fußes kleiner oder gleich der der Gate-Kappe ist;
vorzugsweise umfasst die Gate-Elektrode (104) ein T-förmiges Gate;
und/oder, das Herstellungsverfahren insbesondere ferner umfasst: Bilden einer Seitenwand-Dielektrikschicht zwischen dem Gate-Fuß der Gate-Elektrode (104) und dem hochohmigen Bereich;
und/oder, das Herstellungsverfahren insbesondere ferner umfasst: Bilden einer GaN-Pufferschicht zwischen dem Substrat und der ersten Halbleiterschicht;
und/oder, das Herstellungsverfahren umfasst insbesondere ferner umfasst: Bilden eines Isolationsbereichs, der einen aktiven Bereich in der Epitaxiestruktur isoliert.

15. Verwendung der Hoch-Elektronenbeweglichkeits-Transistorstruktur nach einem der Ansprüche 1 bis 10 bei der Herstellung eines Leistungsverstärkers, eines Hochfrequenzbauelements, eines Kommunikationsgeräts oder eines elektronischen Geräts.

16. Leistungsverstärker, umfassend die Hoch-Elektronenbeweglichkeits-Transistorstruktur nach einem der Ansprüche 1 bis 10.

17. Leistungsverstärker nach Anspruch 16, umfassend einen Leistungsverstärker mit einem Hochfrequenzwellenband, einem Millimeterwellenband oder einem Terahertzwellenband.

## Revendications

1. Structure de transistor à haute mobilité d'électrons, comprenant :
une structure épitaxiale, comprenant une première couche semi-conductrice réalisée en GaN (30) et une deuxième couche semi-conductrice réalisée en AlGaN (60), les première et deuxième couches semi-conductrices faisant partie d'une hétérostructure comprenant une hétérojonction, un canal de support étant formé dans la première couche semi-conductrice au niveau de l'hétérojonction ; et une électrode de source (102), une électrode de drain (103) et une électrode de grille (104) qui sont mises en correspondance avec la structure épitaxiale, l'électrode de source (102) étant connectée électriquement à l'électrode de drain (103) à travers le canal de support ; dans laquelle un taux de coïncidence entre la projection orthographique du pied de grille de l'électrode de grille (104) sur la première couche semi-conductrice et la projection orthographique de la deuxième couche semi-conductrice sur la première couche semi-conductrice est supérieur à 80% ; dans laquelle la structure épitaxiale comprend en outre une couche de contact ohmique, la couche de contact ohmique est en contact avec le canal de support, l'électrode de source et l'électrode de drain sont toutes les deux agencées sur la couche de contact ohmique et forment un contact ohmique avec la couche de contact ohmique ; dans laquelle la couche de contact ohmique comprend une région fortement dopée et une région à résistance élevée, la région fortement dopée est agencée sur l'hétérostructure et forme un contact ohmique avec le canal de support, l'électrode de source (102) et l'électrode de drain (103) forment un contact ohmique avec la région fortement dopée, la région à résistance élevée est agencée sur la région fortement dopée, l'électrode de source (102) est isolée de l'électrode de grille (104) par la région à résistance élevée, et l'électrode de drain (103) est isolée de l'électrode de grille (104) par la région à résistance élevée ; dans laquelle la surface supérieure de la région fortement dopée est plus haute que la surface du canal de support ; et, la région fortement dopée comprend une première région fortement dopée (801) mise en correspondance avec l'électrode de source (102) et une deuxième région fortement dopée (802) mise en correspondance avec l'électrode de drain (103), la première région fortement dopée (801) et la deuxième région fortement dopée (802) sont réalisées en matériaux GaN fortement dopés de type n, la première région fortement dopée (801) et la deuxième région fortement dopée (802) sont respectivement situées sur deux côtés de la deuxième couche semi-conductrice, la région à résistance élevée comprend une première région à résistance élevée (901) mise en correspondance avec l'électrode de source (102) et une deuxième région à résistance élevée (902) mise en correspondance avec l'électrode de drain (103), et des régions au moins partielles de l'électrode de source (102) et de l'électrode de drain (103) pénètrent à travers la première région à résistance élevée (901) et la deuxième région à résistance élevée (902) , respectivement, et sont ensuite en contact ohmique avec la première région fortement dopée (801) et la deuxième région fortement dopée (802), respectivement ; et **caractérisé en ce que** la première région à résistance élevée (901) et la deuxième région à résistance élevée (902) sont réalisées en matériaux GaN à résistance élevée.

2. Structure de transistor à haute mobilité d'électrons selon la revendication 1, dans laquelle le canal de support est réparti dans une région couverte par la projection orthographique de l'électrode de grille (104) sur la structure épitaxiale.

3. Structure de transistor à haute mobilité d'électrons selon la revendication 1, dans laquelle le canal de support est un canal de gaz d'électrons bidimensionnel (40), la deuxième couche semi-conductrice est agencée sur la première couche semi-conductrice.

4. Structure de transistor à haute mobilité d'électrons selon la revendication 3, dans laquelle la première couche semi-conductrice comprend une première région et une deuxième région, une partie renflée est formée dans la première région, la deuxième couche semi-conductrice est agencée sur la partie renflée, la première région fortement dopée et la deuxième région fortement dopée sont agencées sur la deuxième région et réparties sur deux côtés de la partie renflée.

5. Structure de transistor à haute mobilité d'électrons selon la revendication 1, dans laquelle une couche capuchon GaN est répartie entre l'électrode de grille (104) et la deuxième couche semi-conductrice ;
et/ou, la structure épitaxiale comprend en outre une couche d'insertion AlN répartie entre la première couche semi-conductrice et la deuxième couche semi-conductrice.

6. Structure de transistor à haute mobilité d'électrons selon la revendication 5, dans laquelle la structure épitaxiale comprend une surface polaire Ga ou une surface polaire N.

7. Structure de transistor à haute mobilité d'électrons selon la revendication 1, dans laquelle l'électrode de grille (104) comprend un capuchon de grille et le pied de grille, dans laquelle le capuchon de grille est agencé sur la région à résistance élevée et supporté par la région à résistance élevée, le pied de grille est agencé dans la structure épitaxiale, et le canal de support est distribué juste en dessous du pied de grille ;
et/ou, la taille du capuchon de grille dans la direction d'un canal source-drain est supérieure à celle du pied de grille dans la direction du canal source-drain, et la taille du pied de grille dans la direction du canal source-drain est inférieure à la longueur du canal de support ; de préférence, l'électrode de grille (104) est une grille de type T.

8. Structure de transistor à haute mobilité d'électrons selon la revendication 1, dans laquelle une couche diélectrique est agencée entre l'électrode de grille (104) et l'hétérojonction ; et/ou, la couche diélectrique est également utilisée pour isoler électriquement l'électrode de grille (104) et la région à résistance élevée ;
et/ou, la couche diélectrique s'étend également et recouvre la surface de la structure épitaxiale, et l'électrode de source (102) et l'électrode de drain (103) sont mises en correspondance avec la structure épitaxiale à travers des fenêtres correspondantes formées sur la couche diélectrique.

9. Structure de transistor à haute mobilité d'électrons selon la revendication 1, comprenant en outre une région d'isolation formée dans la structure épitaxiale et utilisée pour isoler une région active.

10. Structure de transistor à haute mobilité d'électrons selon la revendication 1, dans laquelle la structure de transistor à haute mobilité d'électrons comprend une structure de dispositif de transistor à haute mobilité d'électrons (HEMT) polaire à l'azote ;
et/ou, la structure à haute mobilité d'électrons appartient à une structure de dispositif à mode d'appauvrissement ou à une structure de dispositif à mode d'amélioration ;
et/ou la structure à haute mobilité d'électrons comprend en outre un substrat où la structure épitaxiale est formée ;
et/ou, la structure épitaxiale comprend en outre une couche tampon de GaN répartie entre le substrat et la première couche semi-conductrice.

11. Procédé de fabrication d'une structure de transistor à haute mobilité d'électrons, comprenant :
une étape de fabrication
d'une structure épitaxiale, la structure épitaxiale comprenant une première couche semi-conductrice réalisée en GaN (30) et une deuxième couche semi-conductrice réalisée en AlGaN (60), les première et deuxième couches semi-conductrices faisant partie d'une hétérostructure comprenant une hétérojonction, et un canal de support étant formé dans la première couche semi-conductrice au niveau de l'hétérojonction, et
une étape de fabrication d'une électrode de source (102), d'une électrode de drain (103) et d'une électrode de grille (104) qui sont mises en correspondance avec la structure épitaxiale, l'électrode de source (102) étant connectée électriquement à l'électrode de drain (103) à travers le canal de support ;
dans lequel, l'étape de fabrication de l'électrode de grille (104) comprend : la taille du pied de grille de l'électrode de grille (104) est réglée de façon à satisfaire aux conditions suivantes : un taux de coïncidence entre la projection orthographique du pied de grille de l'électrode de grille (104) sur la première couche semi-conductrice et la projection orthographique de la deuxième couche semi-conductrice sur la première couche semi-conductrice est supérieur à 80 % ;
dans lequel le procédé de fabrication comprend spécifiquement :
la croissance successive d'une première couche semi-conductrice et d'une deuxième couche semi-conductrice sur un substrat ;
l'agencement d'un masque sur la région d'électrode de grille de la deuxième couche semi-conductrice, dans lequel la taille radiale du masque est cohérente avec celle du pied de grille ;
la gravure de façon à retirer la région de la deuxième couche semi-conductrice qui n'est pas protégée par le masque, dans lequel la profondeur de gravure est une profondeur d'atteinte de la surface de la première couche semi-conductrice ou d'entrée dans la première couche semi-conductrice ;
au moins la croissance de couches de contact ohmique sur la région d'électrode de source et la région d'électrode de drain de la première couche semi-conductrice, et la permission à la hauteur de la surface de la deuxième couche semi-conductrice d'être en dessous de la hauteur de la surface de la couche de contact ohmique, et la mise en contact de la couche de contact ohmique avec le canal de support, dans lequel la couche de contact ohmique comprend une région fortement dopée et une région à résistance élevée ;
la fabrication d'une électrode de grille (104) sur la deuxième couche semi-conductrice après le retrait du masque, et respectivement la fabrication de l'électrode de source (102) et l'électrode de drain (103) sur la région d'électrode de source et la région d'électrode de drain de la couche de contact ohmique, et la permission à l'électrode de source (102) et à l'électrode de drain (103) de former un contact ohmique avec la couche de contact ohmique ;
dans lequel le procédé de fabrication comprend en outre :
la fabrication de la région fortement dopée et de la région à résistance élevée sur l'hétérostructure,
et l'agencement de la région à résistance élevée sur la région fortement dopée, et la permission à la région fortement dopée et au canal de support de former un contact ohmique, formant ainsi la structure épitaxiale ; et
la permission à la fois à l'électrode de source (102) et à l'électrode de drain (103) de former un contact ohmique avec la région fortement dopée, et la permission à l'électrode de source (102) d'être isolée de l'électrode de grille (104) par la région à résistance élevée et la permission à l'électrode de drain (102) d'être isolée de l'électrode de grille (104) par la région à résistance élevée ; le canal de support au niveau de l'hétérostructure étant réparti dans une région couverte par la projection orthographique de l'électrode de grille (104) sur la structure épitaxiale ;
dans laquelle la surface supérieure de la région fortement dopée est plus haute que la surface du canal de support ;
et, la région fortement dopée comprend une première région fortement dopée (801) mise en correspondance avec l'électrode de source (102) et une deuxième région fortement dopée (802) mise en correspondance avec l'électrode de drain (103), la première région fortement dopée (801) et la deuxième région fortement dopée (802) sont réalisées en matériaux GaN fortement dopés de type n, la première région fortement dopée (801) et la deuxième région fortement dopée (802) sont situées respectivement sur deux côtés de la deuxième couche semi-conductrice, la région à résistance élevée comprend une première région à résistance élevée (901) mise en correspondance avec l'électrode de source (102) et une deuxième région à résistance élevée (902) mise en correspondance avec l'électrode de drain (103), et des régions au moins partielles de l'électrode de source (102) et de l'électrode de drain (103) pénètrent à travers la première région à résistance élevée (901) et la deuxième région à résistance élevée (902), respectivement, et sont ensuite en contact ohmique avec la première région fortement dopée (801) et la deuxième région fortement dopée (802), respectivement ; et
**caractérisé en ce que** la première région à résistance élevée (901) et la deuxième région à résistance élevée (902) sont réalisées en matériaux GaN à résistance élevée.

12. Procédé de fabrication selon la revendication 11, comprenant en outre : après la croissance de la couche de contact ohmique, le retrait du masque, puis la formation d'une couche diélectrique continue sur la couche de contact ohmique et la deuxième couche semi-conductrice, puis la fabrication de l'électrode de grille (104) sur la couche diélectrique, et la formation d'une fenêtre sur la couche diélectrique, et la fabrication de l'électrode de source (102) et de l'électrode de drain (103) dans la fenêtre.

13. Procédé de fabrication selon la revendication 11, comprenant spécifiquement :
la croissance d'une première couche semi-conductrice et d'une deuxième couche semi-conductrice sur un substrat ; l'agencement d'un masque sur une région de la surface de la deuxième couche semi-conductrice correspondant à l'électrode de grille (104), la gravure de la deuxième couche semi-conductrice et de la première couche semi-conductrice en utilisant le masque jusqu'à ce que la région de contact d'électrode de source et la région de contact d'électrode de drain de la deuxième couche semi-conductrice soient toutes deux retirées, et la région de contact d'électrode de source et la région de contact d'électrode de drain de la première couche semi-conductrice soient partiellement retirées, de sorte que la région de la première couche semi-conductrice correspondant à l'électrode de grille (104) forme une partie renflée, et la partie restante de la deuxième couche semi-conductrice est répartie sur la partie renflée ;
la croissance des couches fortement dopées sur les parties restantes de la région de contact d'électrode de source et de la région de contact d'électrode de drain de la première couche semi-conductrice et la permission à la surface supérieure de la région fortement dopée d'être plus haute que surface du canal de support, puis la croissance d'une couche à résistance élevée sur la couche fortement dopée pour former une région à résistance élevée, formant ainsi la structure épitaxiale,
ou, la croissance des couches fortement dopées sur les parties restantes de la région de contact d'électrode de source et de la région de contact d'électrode de drain de la première couche semi-conductrice, puis la transformation d'un matériau semi-conducteur à une profondeur spécifiée partant de la surface de la couche fortement dopée vers l'intérieur de la couche fortement dopée en un matériau à résistance élevée de manière à former une région à résistance élevée et une région fortement dopée dans la couche fortement dopée, et la permission à la profondeur spécifiée d'être plus haute que la surface du canal de support de manière à former la structure épitaxiale ; et
le retrait du masque, et la fabrication de l'électrode de source (102), de l'électrode de drain (103) et de l'électrode de grille (104).

14. Procédé de fabrication selon la revendication 11 ou 13, comprenant spécifiquement :
la formation d'une couche diélectrique entre l'électrode de grille (104) et l'hétérojonction ; et/ou, l'électrode de grille (104) comprenant un pied de grille et un capuchon de grille qui sont répartis successivement dans une direction s'éloignant de la deuxième couche semi-conductrice, dans lequel la taille radiale du pied de grille est inférieure ou égale à celle du capuchon de grille ;
de préférence, l'électrode de grille (104) comprend une grille de type T ;
et/ou, le procédé de fabrication comprend en outre spécifiquement : la formation d'une couche diélectrique de paroi latérale entre le pied de grille de l'électrode de grille (104) et la région à résistance élevée ;
et/ou, le procédé de fabrication comprend en outre spécifiquement : la formation d'une couche tampon de GaN entre le substrat et la première couche semi-conductrice ;
et/ou, le procédé de fabrication comprend en outre spécifiquement : la formation d'une région d'isolation isolant une région active dans la structure épitaxiale.

15. Utilisation de la structure de transistor à haute mobilité d'électrons selon l'une quelconque des revendications 1-10 dans la fabrication d'un amplificateur de puissance, d'un dispositif radioélectrique, d'un dispositif de communication ou d'un dispositif électronique.

16. Amplificateur de puissance, comprenant la structure de transistor à haute mobilité d'électrons selon l'une quelconque des revendications 1-10.

17. Amplificateur de puissance selon la revendication 16, comprenant un amplificateur de puissance avec une bande d'ondes radioélectriques, une bande d'ondes millimétriques ou une bande d'ondes térahertz.
